(19) **Europäisches Patentamt / European Patent Office / Office européen des brevets**

(11) **EP 3 485 299 B1**

(12) **FASCICULE DE BREVET EUROPEEN**

(45) Date de publication et mention
de la délivrance du brevet:
**18.09.2024   Bulletin 2024/38**

(21) Numéro de dépôt: **17745436.0**

(22) Date de dépôt: **10.07.2017**

(51) Classification Internationale des Brevets (IPC):
**G01V 3/08** *(2006.01)*      **G01R 33/00** *(2006.01)*
**G01R 33/02** *(2006.01)*

(52) Classification Coopérative des Brevets (CPC):
**G01R 33/02; G01R 33/0035; G01V 3/08**

(86) Numéro de dépôt international:
**PCT/FR2017/051870**

(87) Numéro de publication internationale:
**WO 2018/011492 (18.01.2018 Gazette 2018/03)**

(54) **PROCEDE D'ESTIMATION D'UNE DEVIATION ANGULAIRE ENTRE L'AXE MAGNETIQUE ET UN AXE DE REFERENCE D'UN OBJET MAGNETIQUE**

VERFAHREN ZUR SCHÄTZUNG EINER WINKELABWEICHUNG ZWISCHEN DER MAGNETISCHEN ACHSE UND EINER REFERENZACHSE EINES MAGNETISCHEN OBJEKTS

METHOD FOR ESTIMATING AN ANGULAR DEVIATION BETWEEN THE MAGNETIC AXIS AND A REFERENCE AXIS OF A MAGNETIC OBJECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.07.2016   FR 1656785**
**30.11.2016   FR 1661693**

(43) Date de publication de la demande:
**22.05.2019   Bulletin 2019/21**

(73) Titulaires:
• **Advanced Magnetic Interaction, AMI**
**38170 Seyssinet-Pariset (FR)**
• **Commissariat à l'Energie Atomique et aux Energies Alternatives**
**75015 Paris (FR)**

(72) Inventeurs:
• **ALOUI, Saifeddine**
**38600 Fontaine (FR)**
• **VIAL, Franck**
**38850 Paladru (FR)**
• **DUPRE LA TOUR, Jean-Marie**
**38240 Meylan (FR)**
• **SAUVAGNAC, Guilhem**
**38000 Grenoble (FR)**
• **HAUTSON, Tristan**
**38600 Fontaine (FR)**

(74) Mandataire: **Brevalex**
**Tour Trinity**
**1 B Place de la Défense**
**92400 Courbevoie (FR)**

(56) Documents cités:
**FR-A1- 3 003 039      FR-A1- 3 015 049**
**US-A1- 2012 078 571**

**Description**

**DOMAINE TECHNIQUE**

L'invention porte sur un procédé et un dispositif d'estimation d'une déviation angulaire entre l'axe magnétique du moment magnétique d'un objet magnétique et un axe de référence dudit objet magnétique.

**ÉTAT DE LA TECHNIQUE ANTÉRIEURE**

Il est connu d'utiliser des objets magnétiques, notamment dans le cadre d'un système de relevé de la trace d'un crayon magnétique sur un support d'écriture. L'objet magnétique s'entend ici comme un objet auquel est associé un moment magnétique non nul, par exemple un aimant permanent fixé à un crayon non magnétique.

A titre d'exemple, le document WO2014/053526 décrit un système de relevé de la trace d'un crayon auquel est fixé un aimant permanent annulaire. L'objet magnétique, ici l'aimant permanent, comporte un matériau magnétique, par exemple ferromagnétique ou ferrimagnétique, uniformément réparti autour d'un axe mécanique, dit axe de référence, qui correspond à son axe de révolution. L'aimant est conçu pour que son moment magnétique soit sensiblement colinéaire à l'axe de référence.

Le système de relevé de la trace du crayon muni de l'aimant permanent comporte un réseau de magnétomètres aptes à mesurer le champ magnétique généré par l'aimant permanent. Les magnétomètres sont fixés à un support d'écriture.

Cependant, le procédé de relevé de trace suppose que l'axe magnétique de l'aimant permanent, défini comme l'axe passant par le moment magnétique, soit effectivement colinéaire à l'axe de référence, ou présente une déviation angulaire acceptable entre l'axe magnétique et l'axe de référence. En effet, une déviation angulaire de quelques dixièmes de degrés peut entraîner une erreur sur le relevé de la trace qui peut alors présenter un manque de précision préjudiciable. Il peut alors être nécessaire de procéder à une estimation préalable de la déviation angulaire entre l'axe magnétique et l'axe de référence de l'objet magnétique.

Le document FR3003039A1 porte sur la reconnaissance automatique d'un objet magnétique par comparaison de sa signature magnétique mesurée par un réseau de magnétomètres à une signature magnétique préenregistrée.

**EXPOSÉ DE L'INVENTION**

L'invention a pour objectif de proposer un procédé d'estimation d'une déviation angulaire entre un axe de référence d'un objet magnétique et un axe magnétique colinéaire à un moment magnétique dudit objet magnétique. Pour cela, le procédé d'estimation comporte les étapes suivantes :

a) positionnement dudit objet magnétique vis-à-vis d'au moins un magnétomètre apte à mesurer un champ magnétique en présence de l'objet magnétique ;
b) rotation dudit objet magnétique autour dudit axe de référence ;
c) mesure, au cours de la rotation, du champ magnétique, pour différents instants d'une durée de mesure, par ledit magnétomètre ;
d) estimation de la déviation angulaire à partir des mesures du champ magnétique.

De préférence, l'étape d'estimation comporte :

- une sous-étape d'identification d'un champ magnétique dit minimal et d'un champ magnétique dit maximal à partir des mesures du champ magnétique ; et
- une sous-étape de calcul de la déviation angulaire à partir des champs magnétiques minimal et maximal identifiés, et de paramètres géométriques représentatifs de la position du magnétomètre par rapport à l'objet magnétique.

De préférence, lors de la sous-étape d'identification, les champs magnétiques minimal et maximal sont respectivement identifiés à partir des valeurs minimale et maximale de la norme des mesures du champ magnétique.

De préférence, lesdits paramètres géométriques sont les coordonnées et la distance du magnétomètre par rapport à l'objet magnétique, dans un plan passant par l'axe de référence et contenant le magnétomètre.

La déviation angulaire peut être calculée à partir d'un coefficient égal au rapport de la norme du vecteur formé de la soustraction des champs magnétiques minimal et maximal sur la norme du vecteur formé de la somme des champs magnétiques minimal et maximal, et à partir desdits paramètres géométriques.

La déviation angulaire peut être calculée à partir de l'équation suivante :

$$\overline{\alpha} = \tan^{-1}\left(\left(\frac{\|\mathbf{B_{max}^d} - \mathbf{B_{min}^d}\|}{\|\mathbf{B_{max}^d} + \mathbf{B_{min}^d}\|}\right) \cdot \left(\frac{\sqrt{r^2 z^2 + \left(z^2 - d^2/a\right)^2}}{\sqrt{r^2 z^2 + \left(r^2 - d^2/a\right)^2}}\right)\right)$$

où d est la distance entre le magnétomètre et l'objet magnétique, z et r sont des coordonnées du magnétomètre par rapport à l'objet magnétique suivant un axe, respectivement parallèle et orthogonal, à l'axe de référence, et où a est un coefficient prédéterminé.

Lors de l'étape de rotation, l'objet magnétique peut effectuer au moins un tour autour de l'axe de référence.

Ledit au moins un magnétomètre comporte au moins trois axes de détection du champ magnétique, lesdits axes de détection étant non parallèles entre eux.

De préférence, ledit au moins un magnétomètre est un unique magnétomètre triaxe.

De préférence, ledit au moins un magnétomètre est positionné hors de l'axe de référence ou hors de la perpendiculaire à l'axe de référence passant par l'objet magnétique.

Ledit au moins un magnétomètre peut être positionné par rapport audit objet magnétique à une coordonnée z suivant un axe parallèle à l'axe de référence et une coordonnée r suivant un axe orthogonal à l'axe de référence, de telle manière que la coordonnée z est supérieure ou égale à la coordonnée r.

L'invention porte également sur un procédé de caractérisation d'un objet magnétique présentant une déviation angulaire entre un axe de référence dudit objet magnétique et un axe magnétique colinéaire à un moment magnétique dudit objet magnétique, comportant les étapes suivantes :

- mise en oeuvre du procédé d'estimation de la déviation angulaire selon l'une quelconque des caractéristiques précédentes ;
- calcul d'une amplitude du moment magnétique associé à l'objet magnétique, à partir de la déviation angulaire estimée, du champ magnétique maximal identifié, et desdits paramètres géométriques.

De préférence, l'amplitude du moment magnétique est calculée à partir du rapport entre la norme du champ magnétique maximal et la norme d'un champ magnétique, pour une amplitude unitaire dudit moment magnétique, exprimé de manière analytique par l'équation suivante :

$$\hat{\mathbf{B}}_{\mathbf{max}}^{\mathbf{d}}(\overline{\alpha}, r, z) = \frac{b}{d^5}\begin{pmatrix} -\sin(\overline{\alpha})\dfrac{d^2}{a} + \sin(\overline{\alpha})r^2 + \cos(\overline{\alpha})rz \\ -\cos(\overline{\alpha})\dfrac{d^2}{a} + \cos(\overline{\alpha})z^2 + \sin(\overline{\alpha})rz \end{pmatrix}$$

où $\overline{\alpha}$ est la déviation angulaire préalablement estimée, d est la distance entre le magnétomètre et l'objet magnétique, z et r sont des coordonnées du magnétomètre par rapport à l'objet magnétique suivant un axe, respectivement parallèle et orthogonal, à l'axe de référence, et où a et b sont des coefficients prédéterminés.

Selon un autre mode de réalisation, le procédé d'estimation comporte les étapes suivantes :

a) positionnement dudit objet magnétique vis-à-vis d'un plan de mesure défini par un réseau de magnétomètres aptes à mesurer un champ magnétique en présence de l'objet magnétique ;
b) rotation dudit objet magnétique autour dudit axe de référence ;
c) mesure, au cours de la rotation, du champ magnétique, pour différents instants d'une durée de mesure, par lesdits magnétomètres ;
d) estimation d'un moment magnétique, dit instantané, de l'objet magnétique, auxdits différents instants de mesure, à partir du champ magnétique mesuré ;
e) estimation de la déviation angulaire moyenne à partir desdits moments magnétiques instantanés.

L'étape d'estimation de la déviation angulaire moyenne peut comporter une sous-étape d'estimation d'un vecteur invariant en rotation autour de l'axe de référence à partir des moments magnétiques instantanés, l'estimation de la déviation angulaire moyenne étant effectuée, en outre, à partir dudit vecteur invariant.

L'estimation de la déviation angulaire moyenne peut comporter le calcul d'une amplitude d'écart angulaire entre les moments magnétiques instantanés par rapport au vecteur invariant.

Lors de l'étape de mesure du champ magnétique, l'objet magnétique peut réaliser un nombre entier de tours autour de l'axe de référence supérieur ou égal à 1.

Le procédé d'estimation peut comporter une étape d'homogénéisation d'une répartition angulaire des moments magnétiques instantanés autour de l'axe de référence au cours de la durée de mesure, cette étape d'homogénéisation comportant un calcul par interpolation d'une série temporelle dite homogénéisée de moments magnétiques instantanés, à partir d'une série temporelle dite initiale de moments magnétiques instantanés obtenue préalablement, de sorte que les moments magnétiques instantanés successifs de la série temporelle homogénéisée présentent un écart angulaire sensiblement constant.

L'étape d'homogénéisation peut comporter une phase itérative de calcul de moments magnétiques interpolés dans laquelle un moment magnétique interpolé à une itération considérée est obtenu à partir d'un moment magnétique interpolé à une itération précédente, d'une valeur seuil prédéterminée et d'un vecteur unitaire défini à partir de deux moments magnétiques instantanés successifs de la série temporelle initiale.

L'étape de positionnement peut comporter :

- une sous-étape d'estimation d'un premier paramètre de dispersion représentatif d'une dispersion de l'intensité des moments magnétiques instantanés de l'objet magnétique, pour différentes positions dites verticales de l'objet magnétique suivant un axe sensiblement orthogonal au plan de mesure ;
- une sous-étape de positionnement de l'objet magnétique à une position verticale pour laquelle la valeur du premier paramètre de dispersion est inférieure ou égale à une valeur seuil prédéterminée.

Le procédé d'estimation peut comporter, préalablement à l'étape de positionnement, une étape de mesure, par lesdits magnétomètres, d'un champ magnétique ambiant en l'absence de l'objet magnétique, et peut comporter une sous-étape de soustraction du champ magnétique ambiant aux champs magnétiques préalablement mesurés, de manière à obtenir le champ magnétique généré par l'objet magnétique.

Le procédé d'estimation peut comporter une étape d'application d'un filtre passe-bas aux valeurs de composantes des moments magnétiques instantanés préalablement estimés.

Le filtre passe-bas peut être une moyenne glissante sur un nombre donné d'échantillons.

Le nombre d'échantillons peut être prédéterminé de sorte qu'un biais défini comme un écart entre une déviation angulaire dite réelle et la déviation angulaire moyenne estimée soit minimal, en valeur absolue, pour une valeur dite seuil de déviation angulaire moyenne.

Le procédé d'estimation peut comporter une étape de tri de l'objet magnétique selon l'écart de la valeur estimée de la déviation angulaire moyenne vis-à-vis d'une valeur dite seuil de déviation angulaire moyenne.

Le procédé d'estimation peut comporter une étape d'estimation d'un paramètre dit indicateur de qualité, à partir du calcul d'un deuxième paramètre de dispersion représentatif d'une dispersion des valeurs d'un paramètre dit rayon instantané calculé comme étant la norme d'un vecteur instantané défini entre chaque moment magnétique instantané et le vecteur invariant estimés préalablement.

Le procédé d'estimation peut comporter en outre une étape de comparaison du deuxième paramètre de dispersion à une valeur seuil prédéterminée.

La prédétermination de la valeur seuil peut comporter les sous-étapes suivantes :

- obtention, Q fois avec Q un entier naturel non nul, d'une distribution temporelle dudit rayon instantané, pour un même objet magnétique ;
- estimation, pour chaque distribution temporelle, d'une valeur moyenne dite rayon moyen définie comme la moyenne temporelle du rayon instantané, de manière à obtenir une distribution de Q rayons moyens estimés ;
- estimation, à partir de la distribution des Q rayons moyens estimés, d'une valeur moyenne et un troisième paramètre de dispersion, dite valeur seuil, représentatif d'une dispersion des valeurs des rayons moyens estimés.

L'invention porte également sur un dispositif d'estimation d'une déviation angulaire moyenne entre un axe magnétique et un axe de référence d'un objet magnétique, comportant :

- un réseau de magnétomètres aptes à mesurer, à chaque instant de mesure d'une durée, un champ magnétique perturbé par l'objet magnétique selon au moins un axe de mesure, les magnétomètres étant répartis spatialement de manière à définir un plan de mesure ;
- un organe de maintien et de rotation, apte à maintenir l'objet magnétique dans une position vis-à-vis du plan de mesure, et à mettre en rotation l'objet magnétique suivant son axe de référence ;
- un processeur configuré pour mettre en oeuvre le procédé d'estimation selon l'une quelconque des caractéristiques précédentes.

L'invention porte également sur un support d'enregistrement d'informations, comportant des instructions pour la mise en oeuvre du procédé d'estimation selon l'une quelconque des caractéristiques précédentes, ces instructions étant aptes à être exécutées par un processeur.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1 est une vue schématique en perspective d'un dispositif d'estimation d'une déviation angulaire moyenne d'un objet magnétique selon un premier mode de réalisation ;

la figure 2 est un organigramme d'un exemple de procédé d'estimation d'une déviation angulaire moyenne de l'objet magnétique selon le premier mode de réalisation ;

les figures 3A et 3B illustrent les instants de rotation où le moment magnétique de l'objet est contenu dans un plan défini par l'axe de référence et la position du magnétomètre, et plus précisément lorsque le moment magnétique est contenu dans le demi-plan ne contenant pas le magnétomètre (fig.3A) et lorsqu'il est contenu dans ce demi-plan (fig.3B) ;

la figure 4A est une vue schématique en perspective d'un dispositif d'estimation d'une déviation angulaire moyenne d'un objet magnétique selon un deuxième mode de réalisation, et la figure 4B illustre schématiquement l'évolution temporelle du moment magnétique de l'objet magnétique au cours d'une durée T de mesure, formant ainsi un cercle qui s'étend autour de l'axe de référence ;

la figure 5 est un organigramme d'un exemple de procédé d'estimation d'une déviation angulaire moyenne de l'objet magnétique, selon le deuxième mode de réalisation ;

la figure 6A illustre un exemple d'évolution temporelle de l'écart angulaire élémentaire entre deux moments magnétiques instantanés successifs au cours de la durée T de mesure ; les figures 6B et 6C illustrent de manière schématique un exemple de répartition angulaire non homogène des moments magnétiques instantanés autour de l'axe de référence ; et les figures 6D et 6E illustrent de manière schématique un exemple de répartition angulaire homogène, autour de l'axe de référence, des moments magnétiques instantanés obtenus après une étape d'homogénéisation angulaire ;

la figure 7 est un organigramme d'un exemple partiel d'un procédé d'estimation d'une déviation angulaire moyenne comportant une étape d'homogénéisation angulaire ;

la figure 8A illustre un exemple schématique d'évolution temporelle des composantes du moment magnétique instantané et la figure 8B illustre un exemple d'évolution de la valeur d'un biais sur l'estimation de la déviation angulaire moyenne estimée, en fonction de la valeur de la déviation angulaire réelle, pour différentes valeurs K du nombre d'échantillons pris en compte lors d'une étape de filtrage ;

la figure 9 est un organigramme d'un exemple partiel d'un procédé d'estimation d'une déviation angulaire moyenne comportant une étape de filtrage des moments magnétiques instantanés ;

la figure 10A illustre un exemple d'évolution de l'écart-type de la norme des moments magnétiques instantanés en fonction de la position verticale de l'objet magnétique vis-à-vis du plan de mesure ; et la figure 10B est un organigramme d'un exemple partiel d'un procédé d'estimation d'une déviation angulaire moyenne comportant une étape de positionnement préalable de l'objet magnétique.

**EXPOSÉ DÉTAILLÉ DE MODES DE RÉALISATION PARTICULIERS**

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près, voire à 1% près.

L'invention porte sur un dispositif et un procédé d'estimation de la déviation angulaire moyenne entre l'axe magnétique associé au moment magnétique d'un objet magnétique et un axe mécanique de référence de cet objet.

L'objet magnétique comporte un matériau présentant un moment magnétique, par exemple spontané. Il s'agit de préférence du matériau d'un aimant permanent. L'objet magnétique peut être un aimant permanent cylindrique, par exemple annulaire, tel qu'illustré dans le document WO2014/053526 cité précédemment, auquel cas l'axe de référence correspond à un axe de symétrie de l'aimant, par exemple l'axe de révolution de l'aimant. Il peut également s'agir d'un ustensile ou d'un crayon équipé d'un tel aimant ou comportant un aimant permanent différent, par exemple intégré au corps du crayon, auquel cas l'axe de référence peut correspondre à l'axe longitudinal suivant lequel s'étend le crayon passant par la pointe ou la mine d'écriture du crayon. Le terme crayon est à comprendre au sens large et peut englober les stylos, feutres, pinceaux ou tout autre organe d'écriture ou de dessin.

Le matériau magnétique est de préférence ferrimagnétique ou ferromagnétique. Il présente un moment magnétique spontané non nul même en l'absence d'un champ magnétique extérieur. Il peut présenter un champ magnétique coercitif supérieur à 100 A.m$^{-1}$ ou 500 A.m$^{-1}$ et son intensité est de préférence supérieure à 0,01 A.m$^2$ voire à 0,1 A.m$^2$. On considère par la suite que l'aimant permanent peut être approximé par un dipôle magnétique. L'axe magnétique de l'objet est défini comme étant l'axe colinéaire au moment magnétique de l'objet. L'axe de référence correspond ici à un axe de symétrie de l'objet magnétique. L'écart angulaire entre l'axe de référence et l'axe magnétique est noté déviation angulaire.

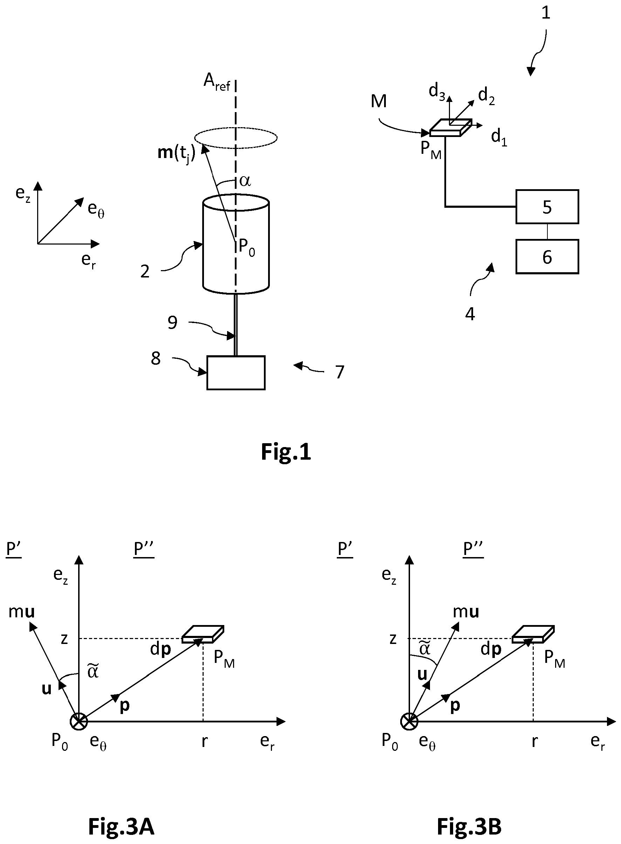

La figure 1 est une vue en perspective, schématique et partielle, d'un dispositif d'estimation 1 d'une déviation angulaire $\overline{\alpha}$ d'un objet magnétique 2 selon un premier mode de réalisation. L'objet magnétique 2 est ici un aimant permanent cylindrique, par exemple annulaire.

Le dispositif d'estimation 1 est apte à mesurer le champ magnétique à différents instants de mesure, au cours d'une durée T de mesure, dans un repère $(e_r, e_\theta, e_z)$, et à estimer la valeur de la déviation angulaire $\overline{\alpha}$ de l'objet magnétique 2 sur la base des valeurs mesurées du champ magnétique.

On définit ici un repère orthogonal direct tridimensionnel $(e_r, e_\theta, e_z)$, où l'axe $e_z$ est colinéaire à l'axe de référence $A_{ref}$, et où les axes sont $e_r$ et $e_\theta$ sont orthogonaux à l'axe $e_z$.

L'aimant 2 est destiné à être positionné au centre du repère $(e_r, e_\theta, e_z)$, de sorte que la position $P_0$ de l'aimant 2 présente dans ce repère les coordonnées (0,0,0). La position $P_0$ de l'aimant 2 correspond aux coordonnées du centre géométrique de l'aimant 2, c'est-à-dire au barycentre non pondéré de l'ensemble des points de l'aimant 2. Ainsi, le moment magnétique **m** de l'aimant 2 présente les composantes $(m_r, m_\theta, m_z)$ dans le repère $(e_r, e_\theta, e_z)$. Sa norme, également appelée intensité ou amplitude, est notée $\|\mathbf{m}\|$ ou m. L'aimant est destiné à être orienté de sorte que l'axe $e_z$, correspondant à l'axe de rotation de l'aimant 2, coïncide avec l'axe de référence $A_{ref}$ de ce dernier. Ainsi, lorsque l'aimant 2 sera mis en rotation autour de son axe de référence $A_{ref}$, le moment magnétique **m** tournera autour de la direction $e_z$.

Le dispositif d'estimation 1 comporte un capteur de mesure du champ magnétique ayant au moins trois axes de mesure $d_1$, $d_2$, $d_3$ distincts deux à deux, c'est-à-dire que les axes de mesure ne sont pas parallèles entre eux, et peut ainsi comporter au moins un magnétomètre triaxe.

Le magnétomètre triaxe M est placé à une position définie $P_M$ $(r, \theta, z)$ vis-à-vis de la position $P_0$ de l'aimant et donc du centre du repère $(e_r, e_\theta, e_z)$. Cette position est connue et constante au cours de toute la durée T de mesure. La connaissance de la position peut présenter une certaine tolérance, par exemple de l'ordre de 10% si l'on accepte une incertitude relative de l'ordre de 20% sur la valeur estimée de la déviation angulaire, ou moins, par exemple de l'ordre de 1% pour une incertitude relative de l'ordre de 2% sur la valeur de la déviation angulaire.

Le magnétomètre M mesure donc l'amplitude et la direction du champ magnétique **B** perturbé par l'aimant 2. Plus précisément, il mesure la norme de la projection orthogonale du champ magnétique **B** suivant les axes de mesure $d_1$, $d_2$, $d_3$. Par champ magnétique perturbé **B,** on entend le champ magnétique ambiant **B$^a$**, c'est-à-dire non perturbé par l'aimant 2, auquel s'ajoute le champ magnétique **B$^d$** généré par l'aimant 2.

Le dispositif d'estimation 1 comporte en outre une unité de calcul 4 apte à stocker les valeurs mesurées du champ magnétique au cours de la durée de mesure, et à déterminer la déviation angulaire $\overline{\alpha}$ de l'aimant permanent 2 à partir des mesures du champ magnétique **B**.

Pour cela, le magnétomètre M est connecté à l'unité de calcul 4, de manière électrique ou autre, par un bus de transmission d'informations (non représenté). L'unité de calcul 4 comporte un processeur programmable 5 apte à exécuter des instructions enregistrées sur un support d'enregistrement d'informations. Il comporte en outre une mémoire 6 contenant les instructions nécessaires pour la mise en oeuvre de certaines étapes d'un procédé d'estimation de la déviation angulaire $\overline{\alpha}$ par le processeur 5. La mémoire 6 est également adaptée à stocker les informations mesurées à chaque instant de mesure.

L'unité de calcul 4 implémente un modèle mathématique associant aux mesures du magnétomètre M le champ magnétique et la position du magnétomètre M vis-à-vis de l'aimant 2 dans le repère $(e_r, e_\theta, e_z)$. Ce modèle mathématique est construit à partir des équations de l'électromagnétisme, en particulier de la magnétostatique, et est paramétré notamment par des paramètres géométriques représentatifs de la position du magnétomètre M vis-à-vis de l'aimant 2 dans le repère $(e_r, e_\theta, e_z)$.

Pour pouvoir approximer l'aimant permanent 2 à un dipôle magnétique, la distance entre l'aimant permanent 2 et le magnétomètre M est supérieure à 2 fois, 3 fois, voire à 5 fois la plus grande dimension de l'aimant permanent 2. Cette dimension peut être inférieure à 20cm, voire inférieure à 10cm, voire à 5cm.

Le dispositif d'estimation 1 comporte également un organe 7 de maintien et de rotation, apte à maintenir l'aimant permanent 2 par rapport au magnétomètre M, dans une position connue et constante au cours de la durée de mesure.

Il est en outre apte à assurer la rotation de l'aimant 2 suivant son axe de référence $A_{ref}$ pendant la durée de mesure. Aussi, pendant la durée de mesure, la position de l'aimant permanent 2 est fixe et seule son orientation autour de l'axe de référence $A_{ref}$ varie au cours du temps. Ainsi, l'axe de référence $A_{ref}$ reste fixe dans le repère $(e_r, e_\theta, e_z)$. L'organe 7 de maintien et de rotation comporte un moteur 8 associé à un bras 9. Le bras 9 peut ainsi recevoir et maintenir l'aimant permanent 2 et assure la rotation de ce dernier. Le bras 9 est réalisé dans un matériau non magnétique et le moteur 8 est suffisamment éloigné de l'aimant permanent 2 et du magnétomètre M pour ne pas induire de perturbation du champ magnétique mesuré. En variante, le dispositif 1 peut ne pas comporter de moteur 8 et peut être adapté à ce que la rotation du bras 9 soit effectuée manuellement.

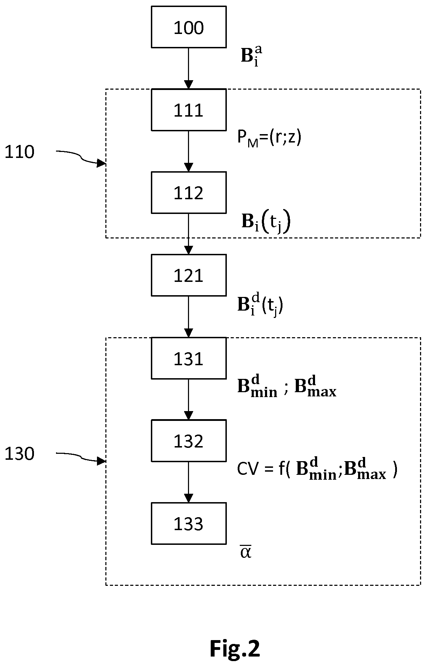

La figure 2 illustre un organigramme d'un exemple de procédé d'estimation de la déviation angulaire $\overline{\alpha}$ que présente l'objet magnétique 2, le procédé étant mis en oeuvre par le dispositif d'estimation de la figure 1.

Le procédé comporte une étape 100 de mesure préalable du champ magnétique ambiant $\mathbf{B^a}$, c'est-à-dire ici le champ magnétique non perturbé par la présence de l'aimant 2. Pour cela, le magnétomètre M est positionné à sa position $P_M$ de mesure, et effectue la mesure le champ magnétique $\mathbf{B_i^a}$ en l'absence de l'aimant 2, c'est-à-dire l'acquisition de la projection du champ magnétique $\mathbf{B^a}$ sur chacun des axes d'acquisition $d_1, d_2, d_3$.

Le procédé comporte ensuite une étape 110 de mesure du champ magnétique perturbé $\mathbf{B}$ par l'aimant 2 en rotation autour de son axe de référence $A_{ref}$ au cours d'une durée T de mesure.

Pour cela, lors d'une sous-étape 111, l'aimant permanent 2 est positionné par l'organe 7 de maintien et de rotation à la position $P_0$ vis-à-vis du magnétomètre M, de telle sorte que l'axe de rotation coïncide avec l'axe de référence $A_{ref}$ de l'aimant 2. Le moment magnétique $\mathbf{m}$ de l'aimant permanent 2 est non colinéaire à l'axe de référence $A_{ref}$ et forme, vis-à-vis de cet axe, une déviation angulaire $\overline{\alpha}$ à déterminer.

Lors d'une sous-étape 112, l'aimant permanent 2 est mis en rotation par l'organe 7 autour de l'axe de référence $A_{ref}$. L'axe de référence $A_{ref}$ est statique au cours de la durée T de mesure, autrement dit sa position et son orientation dans le repère $(e_r, e_\theta, e_z)$ ne varient pas lors de la durée T. La vitesse de rotation de l'aimant permanent 2, notée $\dot{\theta}$, est de préférence constante au cours de la durée T.

Au cours de la rotation, pendant la durée $T=[ti ; t_N]$, un unique magnétomètre triaxe M mesure le champ magnétique $\mathbf{B}$ perturbé par la présence de l'aimant permanent 2, à une fréquence d'échantillonnage fe=N/T. On obtient ainsi N instants $t_j$ de mesure. Le magnétomètre M, à l'instant $t_j$, mesure la projection du champ magnétique vectoriel $\mathbf{B}$ suivant les axes d'acquisition $d_1, d_2, d_3$. On obtient ainsi une série temporelle $\{\mathbf{B}(t_j)\}_N$ de N mesures du champ magnétique perturbé $\mathbf{B}$.

Le procédé comporte ensuite une étape 130 d'estimation de la déviation angulaire magnétique $\overline{\alpha}$ de l'aimant permanent 2, à partir des mesures $\mathbf{B}(t_j)$ du champ magnétique perturbé $\mathbf{B}$.

Au préalable, lors d'une sous-étape 121, l'unité de calcul 4 déduit le champ magnétique généré $\mathbf{B^d}(t_j)$ par l'aimant permanent 2, à chaque instant $t_j$, à partir des mesures du champ magnétique ambiant $\mathbf{B^a}$ et du champ magnétique perturbé $\mathbf{B}(t_j)$. Pour cela, on calcule $\mathbf{B^d}(t_j) = \mathbf{B}(t_j) - \mathbf{B^a}$. On obtient donc une série temporelle $\{\mathbf{B^d}(t_j)\}_N$ de N mesures du champ magnétique généré $\mathbf{B^d}$.

Lors d'une sous-étape 131, l'unité de calcul 4 identifie un champ magnétique dit minimal $\mathbf{B^d_{min}}$ et un champ magnétique dit maximal $\mathbf{B^d_{max}}$ à partir des mesures $\mathbf{B^d}(t_j)$ du champ magnétique $\mathbf{B^d}$. Pour cela, on calcule la norme $\|\mathbf{B^d}(t_j)\|$ de chaque mesure $\mathbf{B^d}(t_j)$ du champ magnétique généré $\mathbf{B^d}$, puis on identifie le champ minimal $\mathbf{B^d_{min}}$ comme étant celui dont la norme est la plus petite, i.e. $\mathbf{B^d_{min}}$ tel que $\|\mathbf{B^d_{min}}\| = \min(\{\|\mathbf{B^d}(t_j)\|\})$, et on identifie le champ maximal $\mathbf{B^d_{max}}$ comme étant celui dont la norme est la plus grande, i.e. $\mathbf{B^d_{max}}$ tel que $\|\mathbf{B^d_{max}}\| = \max(\{\|\mathbf{B^d}(t_j)\|\})$. On obtient ainsi les champs magnétiques minimal $\mathbf{B^d_{min}}$ et maximal $\mathbf{B^d_{max}}$.

Ces sous-étapes 121 de soustraction du champ magnétique ambiant $\mathbf{B^a}$ et 131 d'identification des champs

magnétiques minimal $\mathbf{B_{min}^d}$ et maximal $\mathbf{B_{max}^d}$ peuvent être effectuées en continu, au cours de la sous-étape 112 d'acquisition des mesures du champ magnétique **B**.

Lors des sous-étapes 132 et 133, l'unité de calcul calcule ensuite la déviation angulaire $\overline{\alpha}$ à partir des champs minimal $\mathbf{B_{min}^d}$ et maximal $\mathbf{B_{max}^d}$ identifiés, et de paramètres géométriques représentatifs de la position $P_M$ du magnétomètre vis-à-vis de l'aimant 2.

Comme l'illustrent les figures 3A et 3B, il apparaît que les champs minimal $\mathbf{B_{min}^d}$ et maximal $\mathbf{B_{max}^d}$ sont associés au moment magnétique m lorsque ce dernier appartient à un plan $P=(A_{ref}, P_M)$ du repère $(e_r, e_\theta, e_z)$ contenant l'axe de référence $A_{ref}$ et passant par la position $P_M$ du magnétomètre.

Plus précisément, le champ minimal $\mathbf{B_{min}^d}$ est associé au moment magnétique m lorsque ce dernier appartient au demi-plan P' du plan P délimité par l'axe de référence $A_{ref}$ et ne contenant pas le magnétomètre $P_M$ (fig.3A). Et le champ maximal $\mathbf{B_{max}^d}$ est associé au moment magnétique **m** appartenant au demi-plan P" du plan P délimité par l'axe de référence $A_{ref}$ et contenant le magnétomètre $P_M$ (fig.3B).

Les champs minimal $\mathbf{B_{min}^d}$ et maximal $\mathbf{B_{max}^d}$ peuvent être exprimés de manière analytique, dans le cadre de l'hypothèse dipolaire. En effet, le champ magnétique $\mathbf{B^d}$ généré par l'aimant 2, lorsqu'il appartient au plan P du repère $(e_r, e_\theta, e_z)$, peut être exprimé par l'équation (1) suivante :

$$\mathbf{B^d}(r, z) = 10^{-1} \frac{m}{d^3} (3(\mathbf{u}.\mathbf{p})\mathbf{p} - \mathbf{u}) \qquad (1)$$

où le moment magnétique **m**=m**u** s'écrit comme le produit d'une amplitude m et d'un vecteur unitaire directeur **u**, et où le vecteur de position $P_M$-$P_0$=d**p** du magnétomètre M dans le plan $(e_r, e_z)$ s'écrit comme le produit d'une distance d et d'un vecteur unitaire directeur **p**, le champ magnétique étant exprimé ici en microTesla.

A partir de l'équation (1), le champ minimal $\mathbf{B_{min}^d}$ associé au moment **m** contenu dans le demi-plan P' peut être exprimé de manière analytique par l'équation (2) suivante :

$$\mathbf{B_{min}^d}(\overline{\alpha}, r, z) = \frac{0{,}3\, m}{d^5} \begin{pmatrix} \sin(\overline{\alpha})\frac{d^2}{3} - \sin(\overline{\alpha})r^2 + \cos(\overline{\alpha})rz \\ -\cos(\overline{\alpha})\frac{d^2}{3} + \cos(\overline{\alpha})z^2 - \sin(\overline{\alpha})rz \end{pmatrix} \qquad (2)$$

où (r,z) sont les coordonnées $P_M$ du magnétomètre M dans le plan P par rapport à l'aimant 2, r étant la coordonnée suivant un axe orthogonal à l'axe de référence $A_{ref}$ et z étant la coordonnée suivant un axe parallèle à l'axe de référence $A_{ref}$, et où $d = \sqrt{r^2 + z^2}$ est la distance entre le magnétomètre et l'objet magnétique.

De manière similaire, à partir de l'équation (1), le champ maximal $\mathbf{B_{max}^d}$ associé au moment **m** contenu dans le demi-plan P" peut être exprimé de manière analytique par l'équation (3) suivante :

$$\mathbf{B_{max}^d}(\overline{\alpha}, r, z) = \frac{0{,}3\, m}{d^5} \begin{pmatrix} -\sin(\overline{\alpha})\frac{d^2}{3} + \sin(\overline{\alpha})r^2 + \cos(\overline{\alpha})rz \\ -\cos(\overline{\alpha})\frac{d^2}{3} + \cos(\overline{\alpha})z^2 + \sin(\overline{\alpha})rz \end{pmatrix} \qquad (3)$$

Lors d'une sous-étape 132, à partir des équations (2) et (3), il est possible de calculer un coefficient CV ne dépendant plus de l'amplitude m du moment magnétique, mais uniquement de la déviation angulaire $\overline{\alpha}$ et des paramètres géométriques représentatifs du positionnement du magnétomètre M par rapport à l'aimant 2 dans le plan P.

Ce coefficient CV est avantageusement un coefficient dit de variation, exprimé ici comme le rapport de la norme du vecteur formé par la soustraction des champs minimal $\mathbf{B_{min}^d}(\overline{\alpha}, r, z)$ et champ maximal $\mathbf{B_{max}^d}(\overline{\alpha}, r, z)$ sur la norme

du vecteur formé par la somme des champs minimal $\mathbf{B_{min}^d}(\overline{\alpha}, r, z)$ et maximal $\mathbf{B_{max}^d}(\overline{\alpha}, r, z)$, tel que exprimé de manière analytique par l'équation (4) suivante :

$$CV = \frac{\left\|\mathbf{B_{max}^d}(\overline{\alpha},r,z)-\mathbf{B_{min}^d}(\overline{\alpha},r,z)\right\|}{\left\|\mathbf{B_{max}^d}(\overline{\alpha},r,z)+\mathbf{B_{min}^d}(\overline{\alpha},r,z)\right\|} = \frac{\sin\overline{\alpha}}{\cos\overline{\alpha}}\left(\frac{\sqrt{r^2z^2+\left(r^2-d^2/3\right)^2}}{\sqrt{r^2z^2+\left(z^2-d^2/3\right)^2}}\right) \qquad (4)$$

Il apparaît ainsi que le coefficient de variation CV ne dépend plus de l'amplitude m du moment magnétique, et qu'il est formé du produit d'un premier terme ne dépendant que de la déviation angulaire $\overline{\alpha}$ et d'un deuxième terme ne dépendant que de paramètres géométriques connus tels que les coordonnées (r,z) du magnétomètre M dans le plan P et la distance d séparant le magnétomètre M de l'aimant 2.

Par ailleurs, le coefficient de variation CV peut également être calculé à partir des champs magnétiques minimal $\mathbf{B_{min}^d}$ et maximal $\mathbf{B_{max}^d}$ préalablement identifiés, comme l'exprime la relation suivante :

$$CV = \frac{\left\|\mathbf{B_{max}^d}-\mathbf{B_{min}^d}\right\|}{\left\|\mathbf{B_{max}^d}+\mathbf{B_{min}^d}\right\|} \qquad (5)$$

Aussi, lors d'une sous-étape 133, la déviation angulaire $\overline{\alpha}$ peut être estimée par l'équation (6) suivante obtenue à partir des équations (4) et (5) :

$$\overline{\alpha} = \tan^{-1}\left(\left(\frac{\left\|\mathbf{B_{max}^d}-\mathbf{B_{min}^d}\right\|}{\left\|\mathbf{B_{max}^d}+\mathbf{B_{min}^d}\right\|}\right)\cdot\left(\frac{\sqrt{r^2z^2+\left(z^2-d^2/3\right)^2}}{\sqrt{r^2z^2+\left(r^2-d^2/3\right)^2}}\right)\right) \qquad (6)$$

Ainsi, le procédé d'estimation selon ce premier mode de réalisation permet d'estimer simplement la déviation angulaire $\overline{\alpha}$ de l'objet magnétique 2 sur la base d'un modèle analytique simplifié du champ magnétique $\mathbf{B^d}$ généré par l'aimant 2 associé aux mesures $\mathbf{B^d}(t_j)$ du champ magnétique généré $\mathbf{B^d}$ par l'aimant 2 et à des paramètres géométriques représentatifs de la position du magnétomètre dans un repère dont un axe est colinéaire à l'axe de rotation, lui-même étant confondu avec l'axe de référence $A_{ref}$ de l'objet 2. Il n'est ainsi pas nécessaire de déterminer l'amplitude et l'orientation du moment magnétique, et ce procédé est en outre indépendant de l'orientation du capteur magnétique. En outre, il n'est pas limité à des faibles valeurs de la déviation angulaire. Par ailleurs, il ne nécessite l'utilisation que d'au moins un magnétomètre triaxe, et avantageusement d'un unique magnétomètre triaxe.

De préférence, le magnétomètre M est positionné par rapport à l'aimant 2 de telle sorte que la coordonnée z du magnétomètre dans le plan P est supérieure ou sensiblement égale à la coordonnée r. Les coordonnées r et z sont avantageusement sensiblement égales, permettant ainsi d'améliorer la précision de l'estimation de la déviation angulaire cc.

Par ailleurs, le magnétomètre M est de préférence situé hors de l'axe de référence $A_{ref}$ correspondant à l'axe de rotation de l'aimant 2, et hors de l'axe orthogonal à l'axe de référence $A_{ref}$ et passant par la position $P_0$ de l'aimant 2. Cet agencement permet de bien distinguer les champs magnétiques minimal $\mathbf{B_{min}^d}$ et maximal $\mathbf{B_{max}^d}$ l'un de l'autre. De plus, dans le but d'obtenir un bon rapport signal sur bruit, le magnétomètre est agencé vis-à-vis de l'aimant 2 hors du cône de déviation formé par le moment magnétique m en rotation.

En variante, plusieurs magnétomètres $M_i$ peuvent être utilisés pour estimer la déviation angulaire $\overline{\alpha}$. Selon une approche, il est possible d'effectuer le procédé d'estimation pour chacun des magnétomètres, de manière à obtenir une pluralité de valeurs $\overline{\alpha}_i$ de la déviation angulaire $\overline{\alpha}$, chacune étant associé à un magnétomètre $M_i$. La déviation angulaire $\overline{\alpha}$ est ensuite calculée en moyennant, de manière pondérée ou non, les valeurs $\overline{\alpha}_i$ obtenues. La moyenne est avantageusement pondérée en fonction de l'intensité du signal reçu par chaque magnétomètre.

En variante de l'approche analytique développée précédemment, il est possible d'estimer la déviation angulaire à partir des champs $\mathbf{B_{min}^d}$ et $\mathbf{B_{max}^d}$ identifiés lors de la sous-étape 131, avec l'utilisation de plusieurs magnétomètres distincts les uns des autres en termes de positionnement. Ainsi, dans le cas où le capteur magnétique comporte plusieurs magnétomètres triaxes, l'estimation de la déviation angulaire $\overline{\alpha}$ peut être obtenue par optimisation en minimisant par exemple l'erreur quadratique entre les champs $\mathbf{B}_{\mathbf{min,i}}^{\mathbf{d}}$ et $\mathbf{B}_{\mathbf{max,i}}^{\mathbf{d}}$ préalablement identifiés par chaque magnétomètre $M_i$ et les champs minimal $\widehat{\mathbf{B}_{\mathbf{min,i}}^{\mathbf{d}}}(\widehat{\alpha}, \widehat{m}, r_i, z_i)$ et maximal $\widehat{\mathbf{B}_{\mathbf{max,i}}^{\mathbf{d}}}(\widehat{\alpha}, \widehat{m}, r_i, z_i)$ exprimés par les équations (2) et (3). On cherche ici à résoudre le problème de minimisation formalisé par l'expression suivante :

$$\min_{\widehat{\alpha},\widehat{m}} \left( \sum W_i \left( \left( \widehat{\mathbf{B}_{\mathbf{max,i}}^{\mathbf{d}}}(\widehat{\alpha}, \widehat{m}, r_i, z_i) - \mathbf{B}_{\mathbf{max,i}} \right)^2 + \left( \widehat{\mathbf{B}_{\mathbf{min,i}}^{\mathbf{d}}}(\widehat{\alpha}, \widehat{m}, r_i, z_i) - \mathbf{B}_{\mathbf{min,i}} \right)^2 \right) \right)$$

où $\widehat{\alpha}$ est la valeur estimée de la déviation angulaire, $\widehat{m}$ est l'amplitude estimée du moment magnétique, et où $r_i$ et $z_i$ sont les coordonnées de chaque magnétomètre $M_i$. Le terme $W_i$ est ici un terme de pondération, par exemple dépendant de l'inverse du bruit associé à chaque magnétomètre $M_i$. D'une manière similaire, cette expression de minimisation peut être adaptée au cas où le capteur magnétique comporte une pluralité de magnétomètres scalaires qui mesurent la norme du champ magnétique. Dans ce cas, on minimise l'erreur quadratique entre la norme des champs magnétiques. Ces exemples sont donnés à titre purement illustratif et d'autres approches sont possibles.

Par ailleurs, de préférence, on choisit la fréquence d'échantillonnage, le sens et/ou la vitesse de rotation de manière à améliorer la qualité de l'estimation de la déviation angulaire à, et plus précisément de l'identification des champs magnétiques minimal $\mathbf{B}_{\mathbf{min}}^{\mathbf{d}}$ et maximal $\mathbf{B}_{\mathbf{max}}^{\mathbf{d}}$. Ainsi, lorsque la sous-étape 131 d'identification des champs $\mathbf{B}_{\mathbf{min}}^{\mathbf{d}}$ et $\mathbf{B}_{\mathbf{max}}^{\mathbf{d}}$ est effectuée au cours de la sous-étape 112 d'acquisition des mesures du champ $\mathbf{B}$, la rotation de l'aimant 2 peut comporter une diminution de la vitesse de rotation et/ou une augmentation de la fréquence d'échantillonnage à mesure que l'on s'approche des valeurs minimale $\min(\{\|\mathbf{B}^{\mathbf{d}}(t_j)\|\})$ et maximale $\max(\{\|\mathbf{B}^{\mathbf{d}}(t_j)\|\})$ de la norme du champ magnétique généré $\mathbf{B}^{\mathbf{d}}$. La rotation de l'aimant 2 peut également comporter des phases d'oscillations, c'est-à-dire de changement du sens de rotation, autour de ces valeurs. On réduit ainsi l'incertitude relative associée aux valeurs minimale et maximale, ce qui permet d'améliorer la qualité de l'identification des champs magnétiques minimal $\mathbf{B}_{\mathbf{min}}^{\mathbf{d}}$ et maximal $\mathbf{B}_{\mathbf{max}}^{\mathbf{d}}$, et donc de l'estimation de la déviation angulaire cc.

Par ailleurs, dans le cadre d'un procédé de caractérisation de l'objet magnétique, il peut être avantageux de déterminer en outre l'amplitude m du moment magnétique $\mathbf{m}$, ici dans le cas avantageux où un unique magnétomètre triaxe est utilisé.

L'amplitude m peut ainsi être déterminée à partir de la déviation angulaire $\overline{\alpha}$ estimée, du champ magnétique maximal $\mathbf{B}_{\mathbf{max}}^{\mathbf{d}}$ identifié, et desdits paramètres géométriques, à savoir les coordonnées (r,z) du magnétomètre M et la distance d entre ce dernier et l'aimant 2.

Plus précisément, l'amplitude m du moment magnétique m peut être calculée à partir du rapport entre la norme $\|\mathbf{B}_{\mathbf{max}}^{\mathbf{d}}\|$ du champ magnétique maximal $\mathbf{B}_{\mathbf{max}}^{\mathbf{d}}$ identifié, et la norme $\|\widehat{\mathbf{B}}_{\mathbf{max}}^{\mathbf{d}}(\overline{\alpha}, r, z)\|$ du champ magnétique maximal $\widehat{\mathbf{B}}_{\mathbf{max}}^{\mathbf{d}}(\overline{\alpha}, r, z)$, pour une amplitude unitaire dudit moment magnétique $\mathbf{m}$, exprimé de manière analytiquement par l'équation (7) issue de l'équation (3) :

$$\widehat{\mathbf{B}}_{\mathbf{max}}^{\mathbf{d}}(\overline{\alpha}, r, z) = \frac{0,3}{d^5} \begin{pmatrix} -\sin(\overline{\alpha})\frac{d^2}{3} + \sin(\overline{\alpha})r^2 + \cos(\overline{\alpha})rz \\ -\cos(\overline{\alpha})\frac{d^2}{3} + \cos(\overline{\alpha})z^2 + \sin(\overline{\alpha})rz \end{pmatrix} \tag{7}$$

où $\overline{\alpha}$ est la déviation angulaire préalablement estimée et (r,z) et d sont les paramètres géométriques connus.

L'amplitude m est ainsi calculée à partir de l'équation (8) suivante :

$$m = \frac{\|\mathbf{B}_{\mathbf{max}}^{\mathbf{d}}\|}{\|\widehat{\mathbf{B}}_{\mathbf{max}}^{\mathbf{d}}(\overline{\alpha}, r, z)\|} \tag{8}$$

ce qui permet alors de caractériser l'aimant 2 par la valeur de l'amplitude m d'une part, et de la valeur de la déviation angulaire $\overline{\alpha}$ d'autre part.

En variante, l'amplitude m peut être calculée à partir du champ magnétique minimal $\mathbf{B_{min}^d}$ identifié et de son expression analytique de l'équation (2). L'utilisation du champ magnétique maximal $\mathbf{B_{max}^d}$ permet cependant d'obtenir une meilleure précision.

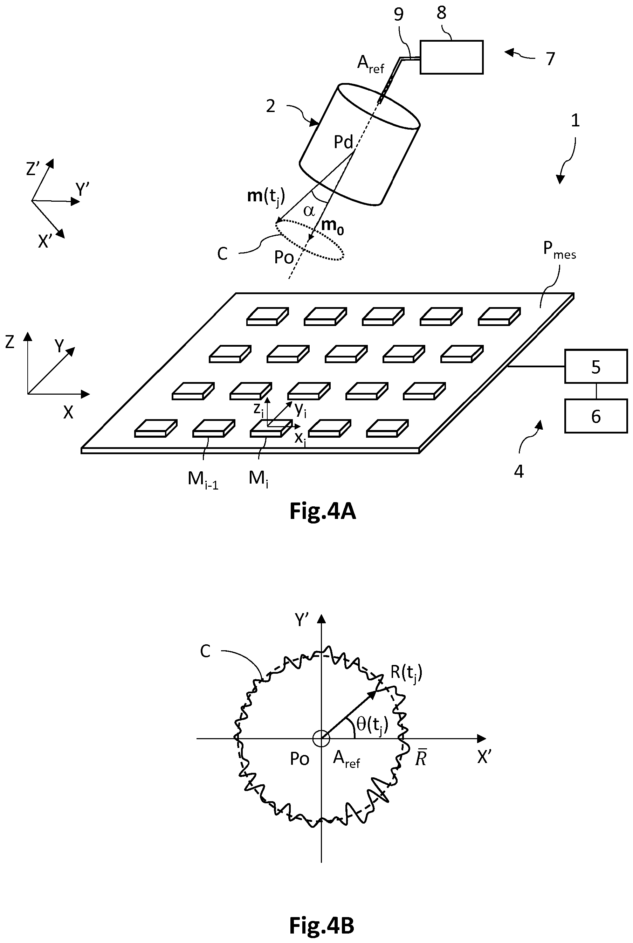

La figure 4A est une vue en perspective, schématique et partielle, d'un dispositif d'estimation 1 d'une déviation angulaire dite moyenne $\overline{\alpha}$ d'un objet magnétique 2, selon un deuxième mode de réalisation, l'objet magnétique étant ici un aimant permanent cylindrique, par exemple annulaire. On nomme ici moment magnétique instantané le vecteur moment magnétique estimé à un instant donné, et déviation angulaire instantanée la valeur de la déviation angulaire estimée à un instant donné.

Le dispositif d'estimation 1 est apte à estimer le moment magnétique instantané à différents instants de mesure au cours d'une durée T de mesure, dans un repère XYZ. Plus précisément, le dispositif 1 permet d'estimer la position de l'aimant permanent 2, et son moment magnétique, à différents instants, dans le repère XYZ. En d'autres termes, le dispositif 1 permet de localiser la position et l'orientation de l'aimant permanent 2 à différents instants dans le repère XYZ.

On définit ici et pour la suite de la description un repère direct tridimensionnel (X,Y,Z), où les axes X et Y forment un plan parallèle au plan de mesure du réseau de magnétomètres, et où l'axe Z est orienté de manière sensiblement orthogonale au plan de mesure. Dans la suite de la description, les termes « vertical » et « verticalement » s'étendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'étendent comme étant relatifs à un positionnement croissant lorsqu'on s'éloigne du plan de mesure suivant la direction +Z.

La position $P_d$ de l'aimant permanent 2 correspond aux coordonnées du centre géométrique de l'aimant 2. Le centre géométrique est le barycentre non pondéré de l'ensemble des points de l'aimant permanent 2. Le moment magnétique m de l'aimant 2 présente les composantes ($m_x$, $m_y$, $m_z$) dans le repère XYZ. Sa norme, ou intensité, est notée $\|\mathbf{m}\|$.

Le dispositif 1 comporte un réseau de magnétomètres $M_i$ répartis les uns vis-à-vis des autres de manière à former un plan de mesure $P_{mes}$. Le nombre de magnétomètres $M_i$ peut être, par exemple supérieur ou égal à 2, de préférence supérieur ou égal à 16, par exemple égal à 32, notamment lorsqu'il s'agit de magnétomètres triaxes. Le réseau de magnétomètres comporte cependant au moins 3 axes de mesure distants les uns des autres et non parallèles deux à deux.

Les magnétomètres $M_i$ sont fixés à une plaque de protection 3 et peuvent être situés au niveau de la face arrière de la plaque 3, celle-ci étant réalisée dans un matériau non magnétique. Par fixés, on entend qu'ils sont assemblés à la plaque 3 sans aucun degré de liberté. Ils sont ici alignés en lignes et colonnes, mais peuvent être positionnés mutuellement de manière sensiblement aléatoire. Les distances entre chaque magnétomètre et ses voisins sont connues et constantes dans le temps. Par exemple, elles peuvent être comprises entre 1cm et 4cm.

Les magnétomètres $M_i$ présentent chacun au moins un axe de mesure, par exemple trois axes, notés $x_i$, $y_i$, $z_i$. Chaque magnétomètre mesure donc l'amplitude et la direction du champ magnétique **B** perturbé par l'aimant permanent. Plus précisément, chaque magnétomètre $M_i$ mesure la norme de la projection orthogonale du champ magnétique **B** suivant les axes $x_i$, $y_i$, $z_i$ du magnétomètre. La sensibilité des magnétomètres $M_i$ peut être de $4.10^{-7}$ T. Par champ magnétique perturbé **B,** on entend le champ magnétique ambiant **B$^a$**, c'est-à-dire non perturbé par l'aimant, auquel s'ajoute le champ magnétique **B$^d$** généré par l'aimant.

Le dispositif d'estimation 1 comporte en outre une unité de calcul 4 apte à calculer la position et l'orientation du moment magnétique de l'aimant 2 dans le repère XYZ à partir des mesures des magnétomètres $M_i$. Il permet en outre de déterminer la déviation angulaire moyenne de l'aimant permanent 2 à partir des mesures du moment magnétique.

Pour cela, chaque magnétomètre $M_i$ est électriquement connecté à l'unité de calcul 4 par un bus de transmission d'informations (non représenté). L'unité de calcul 4 comporte un processeur programmable 5 apte à exécuter des instructions enregistrées sur un support d'enregistrement d'informations. Il comporte en outre une mémoire 6 contenant les instructions nécessaires pour la mise en oeuvre de certaines étapes d'un procédé d'estimation de la déviation angulaire moyenne par le processeur 5. La mémoire 6 est également adaptée à stocker les informations calculées à chaque instant de mesure.

L'unité de calcul 4 implémente un modèle mathématique associant la position de l'aimant permanent 2 dans le repère XYZ, ainsi que l'orientation et l'intensité du moment magnétique, aux mesures des magnétomètres $M_i$. Ce modèle mathématique est construit à partir des équations de l'électromagnétisme, en particulier de la magnétostatique, et est paramétré notamment par les positions et orientations des magnétomètres dans le repère XYZ.

De préférence, pour pouvoir approximer l'aimant permanent 2 à un dipôle magnétique, la distance entre l'aimant permanent 2 et chaque magnétomètre $M_i$ est supérieure à 2, voire 3 fois la plus grande dimension de l'aimant permanent 2. Cette dimension peut être inférieure à 20cm, voire inférieure à 10cm, voire à 5cm.

Le dispositif d'estimation 1 comporte également un organe 7 de maintien et de rotation, apte à maintenir l'aimant permanent 2 vis-à-vis du plan de mesure, dans une position quelconque vis-à-vis du plan de mesure. L'aimant permanent peut être situé au-dessus, c'est-à-dire en regard, du réseau de magnétomètres $M_i$, dans une position verticale suivant l'axe Z constante pendant la durée T de mesure. Il est en outre apte à assurer la rotation du l'aimant 2 suivant son axe de référence $A_{ref}$ pendant la durée de mesure. Aussi, pendant la durée de mesure, la position verticale de l'aimant permanent 2 est fixe et seule sa position angulaire varie du fait de la rotation suivant l'axe de référence $A_{ref}$. L'organe 7 de maintien et de rotation comporte un moteur 8 associé à un bras 9. Le bras 9 peut ainsi recevoir et maintenir l'aimant permanent 2 et assure la rotation de ce dernier. Le bras 9 est réalisé dans un matériau non magnétique et le moteur 8 est suffisamment éloigné du plan de mesure $P_{mes}$ et de l'aimant permanent 2 pour ne pas induire de perturbation du champ magnétique mesuré.

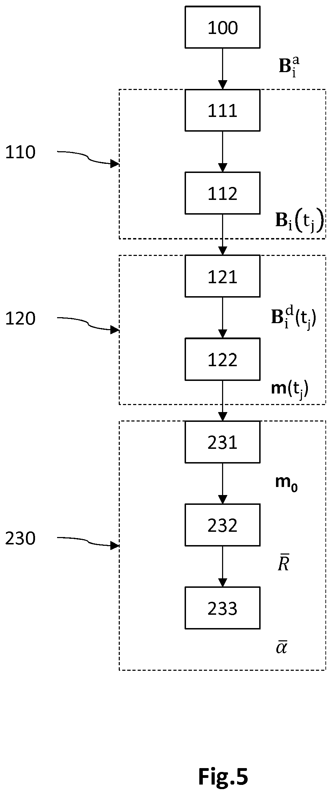

La figure 5 est un organigramme d'un exemple de procédé d'estimation de la déviation angulaire moyenne que présente un objet magnétique, le procédé étant mis en oeuvre par le dispositif d'estimation de la figure 4A.

Le procédé comporte une étape 100 de mesure préalable du champ magnétique ambiant $\mathbf{B^a}$, c'est-à-dire ici le champ magnétique non perturbé par la présence de l'aimant 2. Pour cela, chacun des magnétomètres $M_i$ mesure le champ magnétique $\mathbf{B_{ia}}$ en l'absence de l'aimant 2, c'est-à-dire la projection du champ magnétique $\mathbf{B^a}$ sur chaque axe d'acquisition $x_i$, $y_i$, $z_i$ des différents magnétomètres $M_i$.

Le procédé comporte ensuite une étape 110 de mesure du champ magnétique perturbé par l'aimant 2 en rotation autour de son axe de référence $A_{ref}$ au cours d'une durée T de mesure.

Lors d'une sous-étape 111, l'aimant permanent 2 est positionné vis-à-vis du plan de mesure $P_{mes}$ par l'organe 7 de maintien et de rotation, qui définit l'orientation de l'axe de référence $A_{ref}$ de l'aimant permanent 2 vis-à-vis du plan de mesure $P_{mes}$ dans le repère XYZ. Dans cet exemple, l'aimant permanent 2 est positionné au-dessus du plan de mesure $P_{mes}$ mais tout autre positionnement est possible. L'orientation de l'axe $A_{ref}$ peut être quelconque, mais peut être avantageusement sensiblement orthogonale au plan de mesure $P_{mes}$. Le moment magnétique $\mathbf{m}$ de l'aimant permanent 2 est non colinéaire à l'axe de référence $A_{ref}$ et forme, vis-à-vis de cet axe, une déviation angulaire $\alpha$ à déterminer.

Lors d'une sous-étape 112, l'aimant permanent 2 est mis en rotation par l'organe 7 autour de l'axe de référence $A_{ref}$. L'axe de référence $A_{ref}$ est statique au cours de la durée T de mesure, autrement dit sa position et son orientation dans le repère XYZ ne varient pas lors de la durée T. La vitesse de rotation de l'aimant permanent 2, notée $\hat{\theta}$, est de préférence constante au cours de la durée T.

Au cours de la rotation, pendant la durée T=[ti; $t_N$], chaque magnétomètre $M_i$ mesure le champ magnétique $\mathbf{B_i}(t_j)$ perturbé par la présence de l'aimant permanent 2, à une fréquence d'échantillonnage fe=N/T. On obtient ainsi N instants $t_j$ de mesure. Chaque magnétomètre $M_i$, à l'instant $t_j$, mesure la projection du champ magnétique $\mathbf{B}$ suivant le ou les axes d'acquisition $x_i$, $y_i$, $z_i$. On obtient ainsi une série temporelle $\{\mathbf{B_i}(t_j)\}_N$ de N mesures du champ magnétique perturbé.

Le procédé comporte ensuite une étape 120 d'estimation du moment magnétique instantané $\mathbf{m}(t_j)$ de l'aimant permanent 2, pour chaque instant $t_j$ de mesure, à partir des mesures du champ magnétique perturbé $\mathbf{B_i}(t_j)$.

Lors d'une sous-étape 121, l'unité de calcul 4 déduit le champ magnétique généré $\mathbf{B_i^d}(t_j)$ par l'aimant permanent 2, pour chaque magnétomètre $M_i$ et à chaque instant $t_j$, à partir des mesures du champ magnétique ambiant $\mathbf{B_i^a}$ et du champ magnétique perturbé $\mathbf{B_i}(t_j)$. Pour cela, on calcule $\mathbf{B_i^d}(t_j) = \mathbf{B_i}(t_j) - \mathbf{B_{ia}}$.

Lors d'une sous-étape 122, l'unité de calcul 4 estime la position $P_d$ de l'aimant permanent 2 ainsi que son moment magnétique instantané $\mathbf{m}(t_j)$, à chaque instant $t_j$, à partir du champ magnétique $\mathbf{B_i^d}(t_j)$ préalablement calculé. Pour cela, l'unité de calcul 4 résout un modèle mathématique d'équations de l'électromagnétisme associant la position et le moment magnétique de l'aimant permanent 2 au champ magnétique qu'il génère $\mathbf{B_i^d}(t_j) = f(P_d ; \mathbf{m}(t_j))$. Ainsi, à chaque instant de mesure, l'unité de calcul 4 détermine les coordonnées de la position de l'aimant permanent 2 ainsi que les composantes $m_x$, $m_y$, $m_z$ du moment magnétique instantané, dans le référentiel XYZ. On obtient ainsi une série temporelle $\{\mathbf{m}(t_j)\}_N$ de N vecteurs instantanés du moment magnétique $\mathbf{m}(t_j)$.

Comme le montrent les figures 4A et 4B, la série temporelle $\{\mathbf{m}(t_j)\}_N$ forme un cercle C qui s'étend autour de l'axe de référence $A_{ref}$. Au cercle C peuvent être associés des rayons instantanés $R(t_j)$ relatifs aux moments magnétiques instantanés $\mathbf{m}(t_j)$, ainsi qu'un rayon moyen $\overline{R}$ dont la valeur dépend de la déviation angulaire moyenne $\overline{\alpha}$ à déterminer.

Le procédé comporte ensuite une étape 230 d'estimation de la déviation angulaire moyenne $\overline{\alpha}$ formée par l'écart angulaire entre le moment magnétique $\mathbf{m}$ du dipôle magnétique et l'axe de référence $A_{ref}$.

Lors d'une sous-étape 231, l'unité de calcul estime un vecteur $\mathbf{m}_0$ invariant lors de la rotation de l'aimant permanent 2. Pour cela, on réalise la moyenne temporelle, sur les N instants $t_j$ de mesure, de chaque coordonnée $m_x(t_j)$, $m_y(t_j)$, $m_z(t_j)$ du moment magnétique instantané $\mathbf{m}(t_j)$ dans le repère XYZ. Ainsi, $\mathbf{m_0} = (<m_x(t_j)>_N ; <m_y(t_j)>_N ; <m_z(t_j)>_N)$ $= <\mathbf{m}(t_j)>_N$. L'opérateur $< >_N$ correspond ici à la moyenne temporelle arithmétique, éventuellement pondérée, sur les N instants de mesure. On obtient ainsi un vecteur $\mathbf{m}_0$ sensiblement colinéaire à l'axe de référence $A_{ref}$ qui s'étend entre la position $P_d$ de l'aimant 2 et la position $P_o$ du centre du cercle C.

Lors d'une sous-étape 232, l'unité de calcul estime un paramètre représentatif d'une amplitude moyenne de l'écart angulaire des moments magnétiques instantanés par rapport à l'axe de référence. Ici, ce paramètre est le rayon moyen $\overline{R}$ du cercle C, tel que $\overline{R} = < \|\mathbf{m}(t_j) - \mathbf{m_0}\| >_N$, c'est-à-dire la moyenne temporelle de la norme des vecteurs instantanés $\mathbf{m}(t_j) - \mathbf{m_0}$.

Lors d'une sous-étape 233, l'unité détermine la déviation angulaire moyenne $\overline{\alpha}$ à partir du rayon moyen estimé $\overline{R}$ et, dans cet exemple, du vecteur invariant $\mathbf{m_0}$. Pour cela, il calcule l'arc-tangente du rapport du rayon moyen $\overline{R}$ sur la norme du vecteur invariant $\mathbf{m_0}$ : $\overline{\alpha} = \tan^{-1}(\overline{R}/\|\mathbf{m_0}\|)$. On obtient ainsi une estimation de la déviation angulaire $\overline{\alpha}$ entre l'axe de référence de l'objet magnétique et son axe magnétique.

Bien entendu, d'autres calculs équivalents peuvent être effectués. Ainsi, en variante, lors de la sous-étape 233, l'estimation de la déviation angulaire moyenne peut être obtenue à partir de l'arc-sinus du rapport entre le rayon moyen $\overline{R}$ estimé préalablement et la moyenne temporelle de la norme du moment magnétique instantané $<\|\mathbf{m}(t_j)\|>_N$ sur les N instants $t_j$ de mesure.

Il est également possible, en variante, d'estimer, lors de la sous-étape 232, le rayon instantané $R(t_j)$ du cercle à chaque instant $t_j$ de mesure et de calculer lors de la sous-étape 233, la déviation angulaire instantanée $\alpha(t_j)$ correspondante puis de déterminer la déviation angulaire moyenne $\overline{\alpha}$ comme la moyenne temporelle $<\alpha(t_j)>_N$ des déviations angulaires instantanées sur les N instants $t_j$ de mesure.

Il est également possible, en variante, d'estimer, lors de la sous-étape 232, le rayon moyen $\overline{R}$ par ajustement d'au moins un paramètre d'une équation d'un cercle dans le repère XYZ parcourant la série temporelle des moments magnétiques instantanés, par exemple la série $\{\mathbf{m}(t_j)\}_N$. Ainsi, l'équation du cercle peut être $(m_x(t_j)-P_{0,x})^2-(m_y(t_j)-P_{0,y})^2-(m_z(t_j)-P_{0,z})^2 = \overline{R}$, où $P_{0,x}$, $P_{0,y}$, $P_{0,z}$ sont les coordonnées du centre $P_0$ du cercle C déduites à partir de la position $P_d$ du moment magnétique estimée lors de la sous-étape 122 et du vecteur invariant $\mathbf{m_0}$ estimé lors de la sous-étape 231, et où $m_x(t_j)$, $m_y(t_j)$, $m_z(t_j)$ sont les valeurs des composantes du moment magnétique instantané de la série temporelle $\{\mathbf{m}(t_j)\}_N$ considérée. L'ajustement de la valeur du rayon moyen $\overline{R}$ peut être réalisé de manière connue, par des méthodes classiques de régression, par exemple multilinéaire ou polynomiale.

A titre d'exemple, l'objet magnétique est un aimant permanent à symétrie de révolution autour de son axe de référence $A_{ref}$. Il est positionné par exemple à 4 cm à la verticale d'un réseau de 32 magnétomètres triaxes d'une sensibilité de $4.10^{-7}$T espacés par exemple de 4 cm. La vitesse de rotation est de $\pi/5$ rad/s (1 tour en 10s) et la fréquence d'échantillonnage est de 140Hz. Lors d'une durée T de 10s, l'objet magnétique réalise un unique tour de rotation et le dispositif de détermination acquiert 1400 instants de mesure. L'unité de calcul estime à 0,165 A.m$^2$ l'intensité moyenne du moment magnétique pour un bruit RMS (Root Mean Square, en anglais) de $5.10^{-4}$ A.m$^2$. Le dispositif de détermination estime à 0,01° la déviation angulaire moyenne entre l'axe de référence de l'aimant et son axe magnétique.

De préférence, la durée T de mesure et la vitesse de rotation $\dot{\theta}$ sont choisies de sorte que, pendant la durée T, l'objet magnétique ait effectué un nombre entier de tours complets, par exemple un unique tour. De plus, dans le but d'obtenir une répartition angulaire sensiblement homogène des données de mesure autour de l'axe de référence $A_{ref}$ au cours de la durée T, la rotation élémentaire $\Delta\theta_j$ entre deux instants de mesure $t_j$ et $t_{j+1}$ est sensiblement constante.

Comme détaillé maintenant, dans le cas où les données de mesure ne présentent pas une répartition angulaire sensiblement homogène autour de l'axe de référence $A_{ref}$ pendant la durée T, une étape d'homogénéisation angulaire peut être mise en oeuvre.

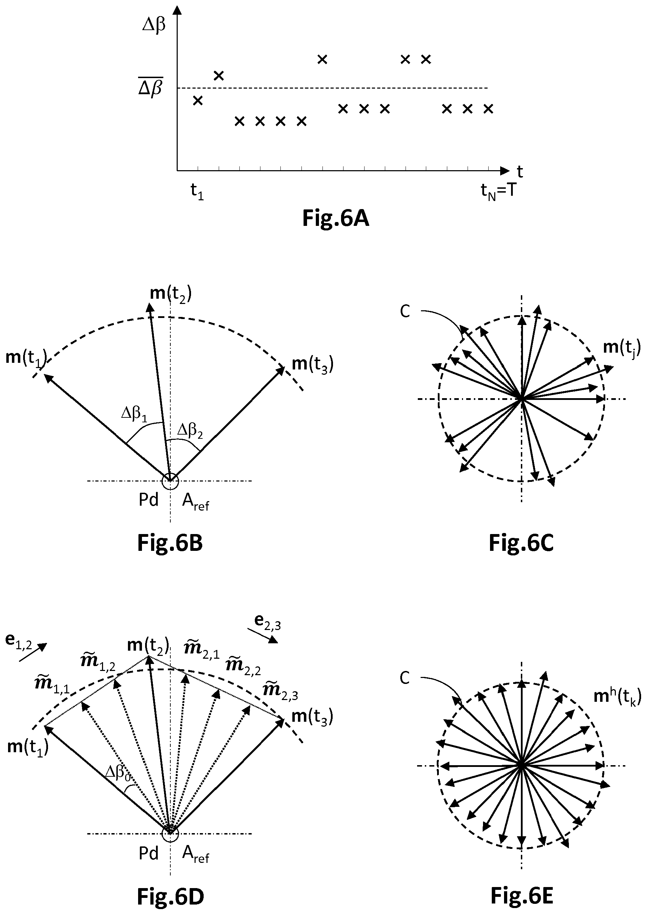

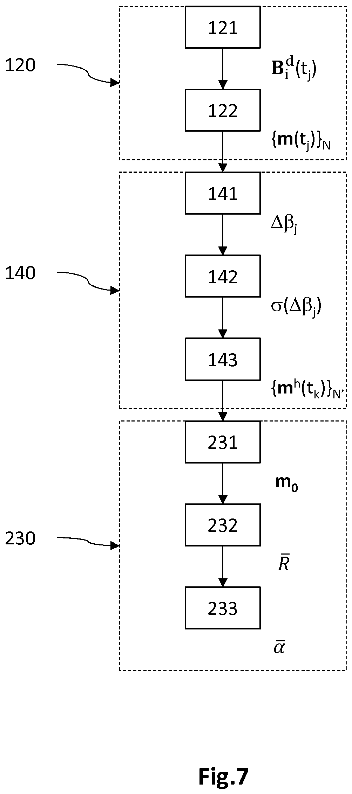

Les figures 6A à 6E et la figure 7 illustrent une étape 140 d'homogénéisation de la répartition angulaire des moments magnétiques instantanés autour de l'axe de référence $A_{ref}$ au cours de la durée T de mesure. Cette étape repose sur le ré-échantillonnage des moments magnétiques instantanés au cours de la durée T de mesure par interpolation, ici au moyen d'une méthode d'interpolation linéaire, de telle sorte que les écarts angulaires entre deux moments magnétiques instantanés successifs soient sensiblement constants. En d'autres termes, on ré-échantillonne une série temporelle initiale de N moments magnétiques instantanés qui présentent une répartition angulaire inhomogène autour de l'axe de référence $A_{ref}$ au cours de la durée T, par exemple la série temporelle $\{\mathbf{m}(t_j)\}_N$ estimée par exemple lors de la sous-étape 122, pour obtenir une série temporelle dite homogénéisée $\{\mathbf{m}^h(t_j)\}_{N'}$ de N' moments magnétiques instantanés qui présentent une répartition angulaire sensiblement homogène.

Cette étape est avantageuse lorsque, comme l'illustrent les figures 6A à 6C, la répartition angulaire des moments magnétiques instantanés autour de l'axe de référence $A_{ref}$ n'est pas homogène au cours de la durée T. Cela se traduit par le fait que les écarts angulaires $\Delta\beta_j$ définis entre deux moments magnétiques instantanés $\mathbf{m}(t_j)$ et $\mathbf{m}(t_{j+1})$, à des instants de mesure $t_j$ et $t_{j+1}$ successifs, présentent une forte dispersion autour de la valeur moyenne $\overline{\Delta\beta}$.

Dans ce cas de figure, le vecteur $\mathbf{m_0}$, calculé lors de la sous-étape 231 décrite ci-dessus, peut ne pas être invariant en rotation, c'est-à-dire peut ne pas être colinéaire à l'axe de référence $A_{ref}$. Cette erreur sur le calcul du vecteur $\mathbf{m_0}$ peut introduire un biais sur la valeur estimée de la déviation angulaire moyenne $\overline{\alpha}$. Cette étape 140 d'homogénéisation permet ainsi de réduire l'erreur sur l'estimation du vecteur invariant $\mathbf{m_0}$.

En référence à la figure 7, cette étape 140 d'homogénéisation peut comporter une sous-étape 141 facultative dans laquelle on estime tout d'abord les écarts angulaires $\Delta\beta_j$ définis par les moments magnétiques estimés $\mathbf{m}$ $(t_j)$ et $\mathbf{m}$ $(t_{j+1})$ à des instants de mesure successifs de la série temporelle initiale, par exemple ici $\{\mathbf{m}$ $(t_j)$ $\}_N$. Pour cela, on peut calculer l'écart angulaire $\Delta\beta_j$ à partir de l'arc sinus de la norme du produit vectoriel de ces deux vecteurs : $\Delta\beta_j = \sin^{-1}$ $\|\mathbf{m}(t_j) \times \mathbf{m}(t_{j+1})\|/(\|\mathbf{m}(t_j)\|.\|\mathbf{m}(t_{j+1})\|)$ où le symbole « x » représente le produit vectoriel et le symbole « . » le produit de scalaires.

Ensuite, lors d'une sous-étape 142 également facultative, l'estimation de la dispersion des écarts angulaires $\Delta\beta_j$ peut être obtenue en calculant l'écart-type $\sigma_{\Delta\beta}$, ou un paramètre équivalent, sur les écarts angulaires $\Delta\beta_j$ estimés. Si la valeur de l'écart-type $\sigma_{\Delta\beta}$ est inférieure à un seuil prédéterminé, les données de mesure présentent une répartition angulaire sensiblement homogène. Dans le cas contraire, on procède à l'homogénéisation de la répartition angulaire des moments magnétiques instantanés autour de l'axe de référence $A_{ref}$ au cours de la durée T de mesure.

Lors d'une sous-étape 143, on ré-échantillonne la série temporelle initiale $\{\mathbf{m}(t_j)\}_N$ par interpolation pour obtenir une série temporelle dite homogénéisée $\{\mathbf{m}^h(t_k)\}_{N'}$ de N' moments magnétiques interpolés, dont les écarts angulaires $\Delta\beta_0$ sont sensiblement constants. Il s'agit d'un sur-échantillonnage lorsque N'>N mais le nombre N' peut être inférieur ou égal à N.

Pour cela, une approche illustrée sur la figure 6D consiste à discrétiser l'écart angulaire $\Delta\beta_j$ entre deux moments magnétiques instantanés successifs $\mathbf{m}(t_j)$ et $\mathbf{m}(t_{j+1})$ de la série temporelle initiale $\{\mathbf{m}(t_j)\}_N$ lorsque sa valeur est supérieure à une valeur seuil prédéterminée $\Delta\beta_0$, par exemple par interpolation linéaire (comme représenté sur la figure 6D) ou par un autre d'interpolation, par exemple polynomiale.

Ainsi, on considère deux moments magnétiques $\mathbf{m}(t_{j+1})$ et $\mathbf{m}(t_j)$ mesurés aux instants successifs $t_j$ et $t_{j+1}$, dont l'écart angulaire $\Delta\beta_j$ présente ici une valeur supérieure au seuil $\Delta\beta_0$. On détermine un vecteur unitaire $\mathbf{e}_{j,j+1}=(\mathbf{m}(t_{j+1})-\mathbf{m}(t_j))/\|\mathbf{m}(t_{j+1})-\mathbf{m}(t_j)\|$. Puis, on calcule un voire plusieurs moments magnétiques interpolés tels que : $\tilde{\mathbf{m}}_{j,k+1} = \tilde{\mathbf{m}}_{j,k} + \Delta\beta_0.\mathbf{e}_{j,j+1}$, avec $\tilde{\mathbf{m}}_{j,k=0} = \mathbf{m}(t_j)$. L'itération sur k se poursuit tant que l'écart angulaire entre $\mathbf{m}(t_{j+1})$ et $\tilde{\mathbf{m}}_{j,k+1}$ est supérieur à $\Delta\beta_0$. A titre illustratif, on considère les moments magnétiques $\mathbf{m}(t_1)$ et $\mathbf{m}(t_2)$ mesurés aux instants successifs $t_1$ et $t_2$, pour lesquels l'écart angulaire $\Delta\beta_1$ présente ici une valeur supérieure au seuil $\Delta\beta_0$. On détermine le vecteur unitaire $\mathbf{e}_{1,2}=(\mathbf{m}(t_2)-\mathbf{m}(t_1))/\|\mathbf{m}(t_2)-\mathbf{m}(t_1)\|$. Puis, on calcule un voire plusieurs moments magnétiques interpolés tels que : $\tilde{\mathbf{m}}_{1,k+1} = \tilde{\mathbf{m}}_{1,k} + \Delta\beta_0.\mathbf{e}_{1,2}$, avec $\tilde{\mathbf{m}}_{1,k=0} = \mathbf{m}(t_{j=1})$ et tant que l'écart angulaire entre $\mathbf{m}(t_2)$ et $\tilde{\mathbf{m}}_{1,k+1}$ est supérieur à $\Delta\beta_0$. Cette sous-étape 143 peut être appliquée à tous les couples de moments magnétiques $\mathbf{m}(t_j)$ et $\mathbf{m}(t_{j+1})$ mesurés à des instants successifs, pour lesquels $\Delta\beta_j>\Delta\beta_0$. A titre d'exemple, sur la figure 6D, trois vecteurs interpolés $\tilde{\mathbf{m}}_{21}, \tilde{\mathbf{m}}_{22}, \tilde{\mathbf{m}}_{23}$ sont calculés entre les moments magnétiques instantanés $\mathbf{m}(t_2)$ et $\mathbf{m}(t_3)$ de telle sorte que les écarts angulaires entre ces moments magnétiques $\mathbf{m}(t_2), \tilde{\mathbf{m}}_{21}, \tilde{\mathbf{m}}_{22}, \tilde{\mathbf{m}}_{23}$ et $\mathbf{m}(t_3)$ sont sensiblement constants et égaux à $\Delta\beta_0$.

On obtient ainsi une série temporelle homogénéisée $\{\mathbf{m}^h\}_{N'}$ de N' moments magnétiques instantanés $\{\mathbf{m}^h\}_{N'}$ correspondant aux N moments magnétiques de la série temporelle initiale $\{\mathbf{m}(t_j)\}_N$ estimés lors de la sous-étape 122 auxquels s'ajoutent les moments magnétiques interpolés $\tilde{\mathbf{m}}$.

En variante (non représentée), on peut construire une série temporelle homogénéisée $\{\mathbf{m}^h\}_{N'}$ sans avoir à y incorporer, comme précédemment, la série temporelle initiale $\{\mathbf{m}(t_j)\}_N$. Ainsi, on peut calculer N' moments magnétiques interpolés tels que : $\tilde{\mathbf{m}}_{k+1} = \tilde{\mathbf{m}}_k + \Delta\beta_0.\mathbf{e}_{j,j+1}$, avec $\tilde{\mathbf{m}}_{k=0} = \mathbf{m}(t_{j=1})$ et avec le vecteur unitaire $\mathbf{e}_{j,j+1}=(\mathbf{m}(t_{j+1})-\mathbf{m}(t_j))/\|\mathbf{m}(t_{j+1})-\mathbf{m}(t_j)\|$. L'itération sur k se poursuit tant que l'écart angulaire entre $\tilde{\mathbf{m}}_{k+1}$ et $\mathbf{m}(t_{j+1})$ est supérieur à $\Delta\beta_0$, et tant que le produit du nombre k d'itérations et de $\Delta\beta_0$ est inférieur à une ou plusieurs fois $2\pi$. De plus, le vecteur unitaire $\mathbf{e}_{j,j+1}$ est défini en j et j+1 de sorte que les écarts angulaires entre $\mathbf{m}(t_j)$ et $\tilde{\mathbf{m}}_{k+1}$ d'une part, et entre $\tilde{\mathbf{m}}_{k+1}$ et $\mathbf{m}(t_{j+1})$ d'autre part, sont inférieurs à l'écart angulaire $\Delta\beta_j$ entre $\mathbf{m}(t_j)$ et $\mathbf{m}(t_{j+1})$. On obtient ainsi la série temporelle homogénéisée $\{\mathbf{m}^h\}_{N'}$ de N' moments magnétiques interpolés.

Au préalable de la sous-étape 143 de calcul de la série temporelle homogénéisée $\{\mathbf{m}^h\}_{N'}$, il est possible d'effectuer un sur-échantillonnage de la série temporelle initiale, par exemple $\{\mathbf{m}(t_j)\}_N$, de préférence par interpolation polynomiale, éventuellement à l'aide de splines, pour ainsi obtenir une nouvelle série temporelle à homogénéiser au moyen de la sous-étape 143 décrite précédemment.

Ainsi, l'écart-type calculé sur les écarts angulaires $\Delta\beta'$ associés à la série temporelle homogénéisée $\{\mathbf{m}^h\}_{N'}$ est alors minimal ou sensiblement nul dans la mesure où ils sont sensiblement égaux à la valeur $\Delta\beta_0$. Les moments magnétiques instantanés $\mathbf{m}^h(t_k)$ présentent alors une répartition angulaire sensiblement homogène autour de l'axe de référence $A_{ref}$ au cours de la durée T de mesure.

La série temporelle homogénéisée $\{\mathbf{m}^h\}_{N'}$ correspond à un ré-échantillonnage des données de mesure à une nouvelle fréquence fe'= N7T, de sorte que chaque moment magnétique instantané $\mathbf{m}^h(t_k)$ de la série temporelle homo-généisée $\{\mathbf{m}^h\}_{N'}$ peut être vue comme une estimation du moment magnétique à différents instants $t_k$ de mesure, avec k={1, 2, ..., N'}.

Le procédé d'estimation de la déviation angulaire moyenne $\bar{\alpha}$ entre l'axe magnétique et l'axe de référence est ensuite poursuivi avec l'étape 230 décrite précédemment. Lors de la sous-étape 231, le vecteur invariant $\mathbf{m}_0$ est déduit

à partir des N' moments magnétiques instantanés $\mathbf{m}^h(t_k)$ de la série temporelle homogénéisée $\{\mathbf{m}^h\}_{N'}$ et non plus à partir des N moments magnétiques instantanés $\mathbf{m}(t_j)$ de la série temporelle $\{\mathbf{m}\}_N$ obtenue lors de la sous-étape 122. De plus, lors de la sous-étape 232, le rayon moyen $\overline{R}$ du cercle C est calculé à partir des moments magnétiques $\mathbf{m}^h(t_k)$ de la série temporelle homogénéisée et/ou à partir des moments magnétiques $\hat{\mathbf{m}}(t_j)$ de la série temporelle filtrée $\{\hat{\mathbf{m}}(t_j)\}_N$ décrite plus loin, et non pas à partir des moments magnétiques $\mathbf{m}(t_j)$ de la série temporelle obtenue lors de la sous-étape 122.

Comme détaillé maintenant, il peut être avantageux d'effectuer une étape 150 de filtrage passe-bas des valeurs des composantes des moments magnétiques instantanés dans le repère XYZ, dans le but de diminuer la dispersion temporelle, autrement dit le bruit de mesure, qu'elles peuvent présenter, par exemple à l'aide d'une moyenne mobile arithmétique ou exponentielle calculée sur un nombre K d'échantillons. C'est particulièrement avantageux lorsque la déviation angulaire moyenne est inférieure à 0,2° et/ou lorsque le bruit associé aux composantes des moments magnétiques est du même ordre de grandeur que la valeur du rayon moyen $\overline{R}$ du cercle C.

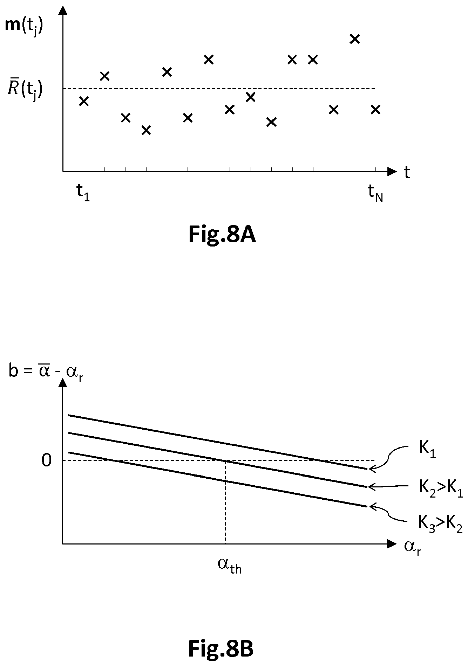

La figure 8A est un diagramme qui illustre de manière schématique la dispersion temporelle des valeurs des composantes $\mathbf{m}(t_j)$ des moments magnétiques instantanés $\mathbf{m}(t_j)$ dans le repère XYZ, ici issus de la série temporelle $\{\mathbf{m}(t_j)\}_N$ obtenue lors de la sous-étape 122.

Cette dispersion des valeurs des composantes $\mathbf{m}(t_j)$ au cours du temps peut induire un biais dans l'estimation de la déviation angulaire moyenne $\overline{\alpha}$. Le biais est ici noté b et est défini comme la différence entre la déviation angulaire réelle $\alpha_r$ de l'aimant permanent 2 et la déviation angulaire moyenne $\overline{\alpha}$, soit $b = \overline{\alpha} - \alpha_r$.

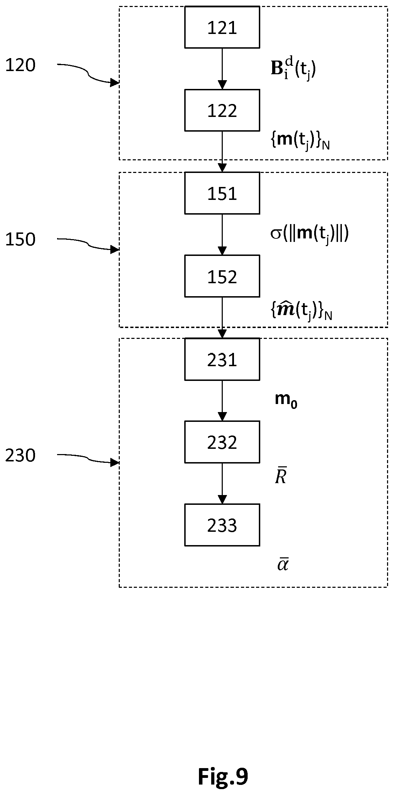

Dans le but de diminuer la dispersion temporelle des valeurs des composantes $m(t_j)$, l'étape 150 de filtrage passe-bas par une moyenne glissante, ou moyenne mobile, peut être effectuée (figure 9).

Lors d'une sous-étape 151 facultative, l'unité calcule l'écart-type $\sigma(\|\mathbf{m}(t_j)\|)$ sur les N valeurs de la norme $\|\mathbf{m}(t_j)\|$ des moments magnétiques instantanés, ou un paramètre équivalent représentatif de la dispersion des valeurs de la norme $\|\mathbf{m}(t_j)\|$ des moments magnétiques instantanés. Si la valeur de l'écart-type $\sigma(\|\mathbf{m}(t_j)\|)$ est supérieure à une valeur seuil prédéterminée, on procède à un filtrage des 3N valeurs de composantes $\mathbf{m}(t_j)$.

Lors d'une sous-étape 152, l'unité applique un filtre $H_K(t_j)$ de type passe-bas, ici par moyenne glissante sur K échantillons, par exemple une moyenne arithmétique ou exponentielle, ou un type de filtre équivalent, sur la série temporelle de 3N valeurs $\{\mathbf{m}(t_j)\}_N$ des composantes des moments magnétiques instantanés dans le repère XYZ. On a donc une nouvelle série temporelle telle que $\{\hat{\mathbf{m}}(t_j)\} = H_K(t_j).\{\mathbf{m}(t_j)\}$, où $\hat{\mathbf{m}}(t_j)$ est les valeurs filtrées des composantes du moment magnétique instantané dans le repère XYZ, à l'instant $t_j$. On obtient ainsi une série temporelle dite filtrée $\{\hat{\mathbf{m}}(t_j)\}_N$ de moments magnétiques instantanés qui est ensuite prise en compte pour l'exécution de l'étape 230 d'estimation de la déviation angulaire moyenne $\overline{\alpha}$.

Bien entendu, cette étape 150 de filtrage passe-bas des composantes des moments magnétiques instantanés peut être appliquée à la série temporelle $\{\mathbf{m}(t_j)\}_N$ obtenue lors de la sous-étape 122, comme à la série temporelle homogénéisée $\{\mathbf{m}^h(t_k)\}_{N'}$.

De préférence, le nombre K d'échantillons est choisi de sorte que le produit de K avec l'écart angulaire moyen $<\Delta\beta_j>$ de la série temporelle considérée, par exemple la série $\{\mathbf{m}(t_j)\}_N$ issue de la sous-étape 122, est inférieur à une valeur donnée, par exemple 45°, et de préférence 10°, voire 5° et de préférence 1°. Alternativement, l'écart angulaire moyen $<\Delta\beta_j>$ peut être obtenu par la vitesse de rotation de l'organe de rotation multipliée par la fréquence d'échantillonnage. On évite ainsi d'appliquer un filtrage trop contraignant à la série temporelle considérée qui risquerait de masquer la dynamique du signal de rotation.

Il est avantageux d'effectuer l'étape 140 d'homogénéisation au préalable de l'étape 231 d'estimation du vecteur invariant $\mathbf{m}_0$. Par ailleurs, il est avantageux d'effectuer l'étape 150 de filtrage au préalable de l'étape 232 d'estimation du rayon moyen $\overline{R}$ du cercle C. Il est enfin avantageux d'effectuer l'étape 150 de filtrage avant l'étape 140 d'homogénéisation pour que la série temporelle prise en compte dans l'étape 140 d'homogénéisation soit moins bruitée.

Comme l'illustre schématiquement la figure 8B, la valeur du biais $b = \overline{\alpha} - \alpha_r$ peut varier en fonction de la valeur de la déviation angulaire réelle $\alpha_r$. Elle est illustrée sur la figure 8B par une fonction affine, mais elle peut présenter un autre type de fonction. Ainsi, il apparaît que la valeur du biais est positive pour les faibles valeurs de déviation angulaire et négative pour les fortes valeurs. Il apparaît également que la valeur de la déviation angulaire réelle pour laquelle la valeur du biais b est sensiblement nulle dépend notamment du nombre K d'échantillons pris en compte dans la moyenne glissante, notamment dans le cas d'une moyenne glissante arithmétique.

Lorsque le procédé d'estimation de la déviation angulaire moyenne $\overline{\alpha}$ comporte une sous-étape supplémentaire de classification de l'aimant permanent 2 en vue d'opérer un tri en fonction d'une valeur de référence $\alpha_{th}$ de la déviation angulaire, il peut être avantageux de déterminer le nombre K d'échantillons à prendre en compte dans la moyenne glissante pour que la valeur du biais soit sensiblement nulle à la valeur de référence $\alpha_{th}$. A titre purement illustratif, pour une valeur de référence $\alpha_{th}$ égale à 0,5° et pour une série temporelle de 1400 moments magnétiques instantanés dont l'intensité moyenne est de 0,165 A.m$^2$ bruitée par un signal RMS de 5.10$^{-4}$ A.m$^2$, une moyenne glissante sur K=10 échantillons peut convenir. On diminue, voire annule ainsi la valeur du biais pour la valeur de référence $\alpha_{th}$.

La sous-étape de classification comporte la comparaison de la valeur estimée de la déviation angulaire moyenne $\overline{\alpha}$ avec la valeur prédéterminée de référence $\alpha_{th}$. Ainsi, on peut opérer une classification et donc un tri des objets magnétiques selon que la déviation angulaire moyenne $\overline{\alpha}$ est supérieure ou inférieure à la valeur de référence $\alpha_{th}$.

A titre illustratif, pour une valeur de référence de 0,5°, on peut considérer que l'aimant permanent 2 est utilisable lorsque sa déviation angulaire estimée est inférieure ou égale à la valeur de référence $\alpha_{th}$ et qu'il est à écarter lorsqu'elle est supérieure à la valeur de référence. En effet, pour une valeur estimée $\overline{\alpha}$ inférieure à la valeur seuil $\alpha_{th}$, le biais est positif, c'est-à-dire que la valeur réelle $\alpha_r$ est inférieure à la valeur estimée. L'aimant permanent est alors utilisable. Par contre, pour une valeur estimée $\overline{\alpha}$ supérieure à la valeur seuil $\alpha_{th}$, le biais est négatif, c'est-à-dire que la valeur réelle $\alpha_r$ est supérieure à la valeur estimée. L'aimant permanent est alors à écarter. Bien entendu, la valeur de référence et la décision de tri dépendent des applications prévues pour l'aimant permanent.

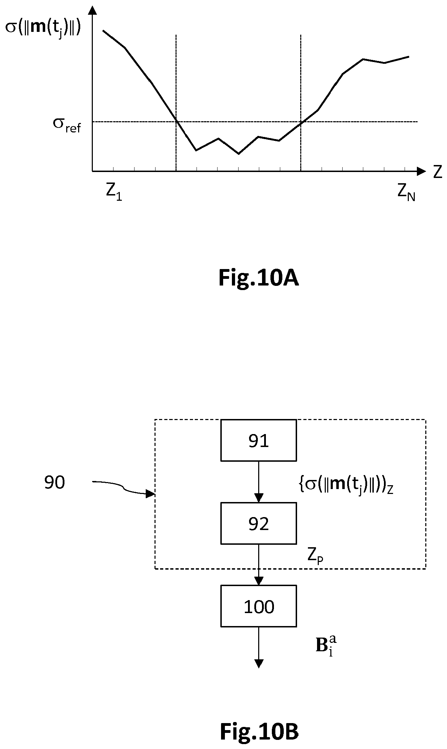

Par ailleurs, le procédé d'estimation de la déviation angulaire peut comporter une étape 90 préalable de positionnement vertical de l'aimant permanent 2 vis-à-vis du plan de mesure P$_{mes}$, décrite en référence aux figures 10A et 10B.

Cette étape de positionnement comporte une sous-étape 91 d'estimation d'un paramètre représentatif de la dispersion des valeurs de l'intensité du moment magnétique instantané, pour différentes positions verticales suivant l'axe Z au-dessus du plan de mesure P$_{mes}$.

Pour cela, les étapes 110 et 120 sont effectuées pour différentes valeurs de positionnement vertical de l'objet suivant l'axe Z. Pour chaque position verticale, on obtient ainsi une série temporelle de moments magnétiques instantanés, par exemple la série temporelle $\{\mathbf{m}(t_j)\}_N$ obtenue lors de la sous-étape 122, et on déduit par exemple l'écart-type $\sigma(\|\mathbf{m}(t_j)\|)$ sur les N valeurs de l'intensité $\|\mathbf{m}(t_j)\|$ des moments magnétiques instantanés. En référence à la figure 10A, on obtient ainsi une série spatiale qui donne la valeur de l'écart-type $\sigma(\|\mathbf{m}(t_j)\|)$ pour différentes positions verticales Z occupées par l'objet magnétique.

Lors d'une sous-étape 92, on sélectionne une valeur de position verticale Z$_P$ pour laquelle la valeur de l'écart-type $\sigma(\|\mathbf{m}(t_j)\|)$ sur l'intensité du moment magnétique instantané est inférieure à une valeur seuil $\sigma_{ref}$. Puis, on positionne l'objet magnétique de sorte qu'il occupe la position verticale Z$_P$.

Le procédé d'estimation de la déviation angulaire moyenne $\overline{\alpha}$ est ensuite poursuivi avec l'étape 100 et les étapes 120 et 230 décrites précédemment, éventuellement complétées par les étapes 140 et 150.

Par ailleurs, le procédé peut comporter une étape supplémentaire d'estimation d'un indicateur de qualité des mesures effectuées pendant la durée T de mesure. Cette étape peut avoir lieu, de préférence, après l'exécution de l'étape 120 ou de l'étape 150.

Pour cela, l'unité de calcul 4 détermine l'écart-type $\sigma_R$ sur les N valeurs du rayon instantané qui est estimé à partir des moments magnétiques instantanés m($t_j$). Le rayon instantané peut être calculé par la relation R($t_j$) = $\|\mathbf{m}(t_j)\text{-}\mathbf{m}_0\|$. Il est calculé ici à partir de la série temporelle $\{\mathbf{m}(t_j)\}_N$ obtenue lors de la sous-étape 122. L'indicateur de qualité est ici la grandeur $\sigma_R/\sqrt{N}$ qui permet de caractériser la précision de la série de mesures. D'autres indicateurs de qualité peuvent être utilisés à partir de l'écart-type $\sigma_R$, par exemple asin( ($\sigma_R/\sqrt{N}$)/ (< $\|\mathbf{m}(t_j)\|$ >$_N$) ) ou atan/ ($\sigma_R/\sqrt{N}$)/($\|\mathbf{m}_0\|$) ).

Dans le but de détecter une éventuellement anomalie ayant eu lieu lors de la série de mesure, l'écart-type $\sigma_R$ sur les N valeurs du rayon instantané peut être comparé à une valeur de référence $\sigma(\overline{R})$ préalablement déterminée. Cette valeur $\sigma(\overline{R})$ peut être déterminée en effectuant un grand nombre Q d'estimations du rayon moyen $\overline{R}$ pour un même type d'aimant permanent 2. Le nombre Q peut être supérieur à 100 voire supérieur ou égal à 1000. Le rayon moyen $\overline{R}$ est par exemple estimé en exécutant les étapes 120 et 230, éventuellement complétées par les étapes 140 et 150. Ainsi, on obtient Q fois une distribution temporelle $\{R(t_j)\}_N$ dudit rayon instantané R($t_j$), pour un même objet magnétique. Q est un entier naturel non nul, de préférence supérieur ou égal à 50, voire à 100. Puis on estime, pour chacune des Q distributions temporelles $\{R(t_j)\}_N$, une valeur moyenne dite rayon moyen $\overline{R}$ défini comme la moyenne temporelle du rayon instantané <R($t_j$)>$_N$. On obtient ainsi une distribution $\{\overline{R}\}_Q$ de Q rayons moyens estimés $\overline{R}$. A partir de cette distribution, on estime la valeur moyenne <$\overline{R}$>$_Q$ ainsi qu'un paramètre d'estimation de la dispersion des valeurs des rayons moyens estimés $\overline{R}$ autour de la moyenne <$\overline{R}$>$_Q$, telle que l'écart-type $\sigma(\overline{R})$. On compare la grandeur $\sigma_R$ à $\sigma(\overline{R})$, par exemple en calculant le rapport $\sigma_R/\sigma(\overline{R})$. Lorsque ce rapport est supérieur ou égal à une valeur seuil, par exemple 1, 2 voire 3, on peut estimer que les mesures effectuées pendant la durée T ne sont pas représentatives et ne doivent donc pas être prises en compte. Cette erreur liée aux mesures peut être issue d'un problème mécanique, par exemple un problème de stabilité de l'axe de référence, voire un problème de détection magnétique, par exemple une magnétisation excessive d'un ou plusieurs magnétomètres.

**EP 3 485 299 B1**

**Revendications**

1. Procédé d'estimation d'une déviation angulaire $(\overline{\alpha})$ entre un axe de référence (A$_{ref}$) d'un objet magnétique (2) et un axe magnétique colinéaire à un moment magnétique (**m**) dudit objet magnétique (2), comportant les étapes suivantes :

   a) positionnement (90 ; 110) dudit objet magnétique (2) vis-à-vis d'au moins un magnétomètre (M$_i$) apte à mesurer un champ magnétique (**B**) en présence de l'objet magnétique (2) ;
   b) rotation (110) dudit objet magnétique (2) autour dudit axe de référence (A$_{ref}$) ;
   c) mesure (110), au cours de la rotation, du champ magnétique (**B$_i$**(t$_j$)), pour différents instants (t$_j$) d'une durée (T) de mesure, par ledit magnétomètre (M$_i$);
   d) estimation (130 ; 230) de la déviation angulaire $(\overline{\alpha})$ à partir des mesures (**B$_i$**(t$_j$)) du champ magnétique (**B$_i$**).

2. Procédé selon la revendication 1, dans lequel l'étape d'estimation (130) comporte :

   - une sous-étape d'identification d'un champ magnétique dit minimal ( $\mathbf{B}_{min}^{d}$ ) et d'un champ magnétique dit maximal ( $\mathbf{B}_{max}^{d}$ ) à partir des mesures (**B$^d$**(t$_j$)) du champ magnétique (**B$^d$**) ; et

   - une sous-étape de calcul de la déviation angulaire $(\overline{\alpha})$ à partir des champs magnétiques minimal ( $\mathbf{B}_{min}^{d}$ ) et maximal ( $\mathbf{B}_{max}^{d}$ ) identifiés, et de paramètres géométriques (r,z ; d) représentatifs de la position du magnétomètre (M) par rapport à l'objet magnétique (2).

3. Procédé selon la revendication 2, dans lequel, lors de la sous-étape d'identification, les champs magnétiques minimal ( $\mathbf{B}_{min}^{d}$ ) et maximal ( $\mathbf{B}_{max}^{d}$ ) sont respectivement identifiés à partir des valeurs minimale et maximale de la norme ($\|\mathbf{B^d(t_j)}\|$) des mesures (**B$^d$**(t$_j$)) du champ magnétique (**B$^d$**).

4. Procédé selon la revendication 2 ou 3, dans lequel lesdits paramètres géométriques (r,z ; d) sont les coordonnées (r,z) et la distance (d) du magnétomètre (M) par rapport à l'objet magnétique (2), dans un plan passant par l'axe de référence (A$_{ref}$) et contenant le magnétomètre (M).

5. Procédé selon l'une quelconque des revendications 2 à 4, dans lequel la déviation angulaire $(\overline{\alpha})$ est calculée à partir d'un coefficient (CV) égal au rapport de la norme du vecteur formé de la soustraction des champs magnétiques minimal ( $\mathbf{B}_{min}^{d}$ ) et maximal ( $\mathbf{B}_{max}^{d}$ ) sur la norme du vecteur formé de la somme des champs magnétiques minimal ( $\mathbf{B}_{min}^{d}$ ) et maximal ( $\mathbf{B}_{max}^{d}$ ), et à partir desdits paramètres géométriques (r,z ; d).

6. Procédé selon l'une quelconque des revendications 2 à 5, dans lequel la déviation angulaire $(\overline{\alpha})$ est calculée à partir de l'équation suivante :

$$\overline{\alpha} = \tan^{-1}\left( \left( \frac{\|\mathbf{B}_{max}^{d} - \mathbf{B}_{min}^{d}\|}{\|\mathbf{B}_{max}^{d} + \mathbf{B}_{min}^{d}\|} \right) \cdot \left( \frac{\sqrt{r^2z^2 + \left(z^2 - d^2/a\right)^2}}{\sqrt{r^2z^2 + \left(r^2 - d^2/a\right)^2}} \right) \right)$$

où d est la distance entre le magnétomètre et l'objet magnétique, z et r sont des coordonnées du magnétomètre par rapport à l'objet magnétique suivant un axe, respectivement parallèle (e$_z$) et orthogonal (e$_r$), à l'axe de référence (A$_{ref}$), et où a est un coefficient prédéterminé.

7. Procédé selon l'une quelconque des revendications 1 à 6, dans lequel, lors de l'étape de rotation, l'objet magnétique (2) effectue au moins un tour autour de l'axe de référence (A$_{ref}$).

8. Procédé selon l'une quelconque des revendications 1 à 7, dans lequel ledit au moins un magnétomètre (M) comporte au moins trois axes de détection du champ magnétique, lesdits axes de détection étant non parallèles entre eux.

9. Procédé selon l'une quelconque des revendications 1 à 8, dans lequel ledit au moins un magnétomètre (M) est un unique magnétomètre triaxe.

10. Procédé selon l'une quelconque des revendications 1 à 9, dans lequel ledit au moins un magnétomètre (M) est positionné hors de l'axe de référence ($A_{ref}$) ou hors de la perpendiculaire à l'axe de référence ($A_{ref}$) passant par l'objet magnétique.

11. Procédé selon l'une quelconque des revendications 1 à 10, dans lequel ledit au moins un magnétomètre (M) est positionné par rapport audit objet magnétique à une coordonnée z suivant un axe ($e_z$) parallèle à l'axe de référence ($A_{ref}$) et une coordonnée r suivant un axe ($e_r$) orthogonal à l'axe de référence ($A_{ref}$), de telle manière que la coordonnée z est supérieure ou égale à la coordonnée r.

12. Procédé de caractérisation d'un objet magnétique (2) présentant une déviation angulaire ($\overline{\alpha}$) entre un axe de référence ($A_{ref}$) dudit objet magnétique (2) et un axe magnétique colinéaire à un moment magnétique (**m**) dudit objet magnétique (2), comportant les étapes suivantes :

   - mise en oeuvre du procédé d'estimation de la déviation angulaire ($\overline{\alpha}$) selon l'une quelconque des revendications 2 à 11 dépendant de la revendication 2 ;
   - calcul d'une amplitude (m) du moment magnétique (**m**) associé à l'objet magnétique (2), à partir de la déviation angulaire ($\overline{\alpha}$) estimée, du champ magnétique maximal ( $\mathbf{B_{max}^d}$ ) identifié, et desdits paramètres géométriques (r,z ; d).

13. Procédé selon la revendication 12, dans lequel l'amplitude (m) du moment magnétique est calculée à partir du rapport entre la norme du champ magnétique maximal ( $\mathbf{B_{max}^d}$ ) et la norme d'un champ magnétique ( $\mathbf{\hat{B}_{max}^d}(\overline{\alpha}, r, z)$ ), pour une amplitude unitaire dudit moment magnétique (**m**), exprimé de manière analytique par l'équation suivante :

$$\mathbf{\hat{B}_{max}^d}(\overline{\alpha}, r, z) = \frac{b}{d^5} \begin{pmatrix} -\sin(\overline{\alpha})\dfrac{d^2}{a} + \sin(\overline{\alpha})r^2 + \cos(\overline{\alpha})rz \\ -\cos(\overline{\alpha})\dfrac{d^2}{a} + \cos(\overline{\alpha})z^2 + \sin(\overline{\alpha})rz \end{pmatrix}$$

où $\overline{\alpha}$ est la déviation angulaire préalablement estimée, d est la distance entre le magnétomètre (M) et l'objet magnétique (2), z et r sont des coordonnées du magnétomètre (M) par rapport à l'objet magnétique (2) suivant un axe, respectivement parallèle ($e_z$) et orthogonal ($e_r$), à l'axe de référence ($A_{ref}$), et où a et b sont des coefficients prédéterminés.

14. Procédé d'estimation selon la revendication 1, comportant les étapes suivantes :

   - positionnement (90 ; 110) dudit objet magnétique (2) vis-à-vis d'un plan de mesure ($P_{mes}$) défini par un réseau de magnétomètres ($M_i$) aptes à mesurer un champ magnétique (**B**) en présence de l'objet magnétique (2) ;
   - estimation (120) d'un moment magnétique, dit instantané, (**m**($t_j$)) de l'objet magnétique (2), auxdits différents instants ($t_j$) de mesure, à partir du champ magnétique mesuré (**B**$_i$($t_j$)) ;
   - estimation (230) de la déviation angulaire dite moyenne ($\overline{\alpha}$) à partir desdits moments magnétiques instantanés (**m**($t_j$)).

15. Procédé selon la revendication 14, dans lequel l'étape d'estimation (230) de la déviation angulaire moyenne ($\overline{\alpha}$) comporte une sous-étape d'estimation (231) d'un vecteur (**m_o**) invariant en rotation autour de l'axe de référence ($A_{ref}$) à partir des moments magnétiques instantanés (**m**($t_j$)), l'estimation (230) de la déviation angulaire moyenne ($\alpha$) étant effectuée, en outre, à partir dudit vecteur invariant (**m_o**).

16. Dispositif d'estimation (1) d'une déviation angulaire ($\overline{\alpha}$) entre un axe de référence ($A_{ref}$) d'un objet magnétique (2) et un axe magnétique colinéaire à un moment magnétique (**m**) dudit objet magnétique (2), comportant :

- au moins un magnétomètre ($M_i$) apte à mesurer, à chaque instant de mesure d'une durée (T), un champ magnétique perturbé par l'objet magnétique (2) ;
- un organe (7) de maintien et de rotation, apte à maintenir l'objet magnétique (2) dans une position déterminée vis-à-vis dudit au moins un magnétomètre ($M_i$), et à mettre en rotation l'objet magnétique (2) suivant son axe de référence ($A_{ref}$) ;
- un processeur (5) configuré pour mettre en oeuvre le procédé selon l'une quelconque des revendications 1 à 15.

**17.** Support d'enregistrement d'informations, comportant des instructions qui conduisent le dispositif d'estimation (1) selon la revendication 16 à exécuter les étapes du procédé selon l'une quelconque des revendications 1 à 15.

**Patentansprüche**

**1.** Verfahren zum Schätzen einer Winkelabweichung ($\overline{\alpha}$) zwischen einer Referenzachse ($A_{ref}$) eines magnetischen Objekts (2) und einer magnetischen Achse, die kolinear zu einem magnetischen Moment (**m**) des magnetischen Objekts (2) verläuft, umfassend die folgenden Schritte:

a) Positionieren (90; 110) des magnetischen Objekts (2) gegenüber mindestens einem Magnetometer ($M_i$), der dazu ausgelegt ist, ein Magnetfeld (**B**) in Gegenwart des magnetischen Objekts (2) zu messen;
b) Drehen (110) des magnetischen Objekts (2) um die Referenzachse ($A_{ref}$);
c) Messen (110) des Magnetfelds ($\mathbf{B}_i(t_j)$) zu verschiedenen Zeitpunkten ($t_j$) einer Messdauer (T) mit dem Magnetometer ($M_i$) während des Drehens;
d) Schätzen (130; 230) der Winkelabweichung ($\overline{\alpha}$) anhand der Messungen ($\mathbf{B}_i(t_j)$) des Magnetfelds ($\mathbf{B}_i$).

**2.** Verfahren nach Anspruch 1, wobei der Schritt des Schätzens (130) Folgendes umfasst:

- einen Unterschritt des Identifizierens eines minimalen Magnetfelds ($B_{min}^d$) und eines maximalen Magnetfelds ($B_{max}^d$) anhand der Messungen ($\mathbf{B}(t_j)$) des Magnetfelds ($\mathbf{B}^d$); und

- einen Unterschritt des Berechnens der Winkelabweichung ($\overline{\alpha}$) anhand des identifizierten minimalen ($B_{min}^d$) und des identifizierten maximalen (Bmax) Magnetfelds und von geometrischen Parametern (r,z; d), die die Position des Magnetometers (M) im Verhältnis zum magnetischen Objekt (2) darstellen.

**3.** Verfahren nach Anspruch 2, wobei während des Unterschritts des Identifizierens das minimale ($\mathbf{B}_{min}^d$) und das maximale ($\mathbf{B}_{max}^d$) Magnetfeld jeweils anhand der minimalen und maximalen Werte der Norm ($\|\mathbf{B}^d(t_j)\|$) der Messungen ($\mathbf{B}^d(t_j)$) des Magnetfelds ($\mathbf{B}^d$) identifiziert werden.

**4.** Verfahren nach Anspruch 2 oder 3, wobei die geometrischen Parameter (r,z; d) die Koordinaten (r,z) und der Abstand (d) des Magnetometers (M) in Bezug auf das magnetische Objekt (2) in einer Ebene sind, die durch die Referenzachse ($A_{ref}$) verläuft und das Magnetometer (M) enthält.

**5.** Verfahren nach einem der Ansprüche 2 bis 4, wobei die Winkelabweichung ($\overline{\alpha}$) anhand eines Koeffizienten (CV), der dem Verhältnis der Norm des Vektors, der aus der Subtraktion des minimalen ($\mathbf{B}_{min}^d$) und des maximalen ($\mathbf{B}_{max}^d$) Magnetfelds gebildet wird, zur Norm des Vektors entspricht, der aus der Summe des minimalen ($\mathbf{B}_{min}^d$) und maximalen ($\mathbf{B}_{max}^d$) Magnetfelds gebildet wird, und anhand der geometrischen Parameter (r,z; d) berechnet wird.

**6.** Verfahren nach einem der Ansprüche 2 bis 5, wobei die Winkelabweichung ($\overline{\alpha}$) anhand der folgenden Gleichung berechnet wird:

$$\overline{\alpha} = \tan^{-1}\left(\left(\frac{\|\mathbf{B}^{\mathbf{d}}_{\mathbf{max}} - \mathbf{B}^{\mathbf{d}}_{\mathbf{min}}\|}{\|\mathbf{B}^{\mathbf{d}}_{\mathbf{max}} + \mathbf{B}^{\mathbf{d}}_{\mathbf{min}}\|}\right) \cdot \left(\frac{\sqrt{r^2 z^2 + \left(z^2 - d^2/a\right)^2}}{\sqrt{r^2 z^2 + \left(r^2 - d^2/a\right)^2}}\right)\right)$$

wobei d der Abstand zwischen dem Magnetometer und dem magnetischen Objekt ist, z und r Koordinaten des Magnetometers im Verhältnis zum magnetischen Objekt entlang einer Achse sind, die jeweils parallel ($e_z$) und orthogonal ($e_r$) zur Referenzachse ($A_{ref}$) verläuft, und wobei a ein vorbestimmter Koeffizient ist.

7. Verfahren nach einem der Ansprüche 1 bis 6, wobei das magnetische Objekt (2) während des Schritts des Drehens mindestens eine Drehung um die Referenzachse ($A_{ref}$) ausführt.

8. Verfahren nach einem der Ansprüche 1 bis 7, wobei das mindestens eine Magnetometer (M) mindestens drei Achsen zum Erfassen des Magnetfelds umfasst, wobei die Erfassungsachsen nicht parallel zueinander verlaufen.

9. Verfahren nach einem der Ansprüche 1 bis 8, wobei das mindestens eine Magnetometer (M) ein einzelnes dreiachsiges Magnetometer ist.

10. Verfahren nach einem der Ansprüche 1 bis 9, wobei das mindestens eine Magnetometer (M) außerhalb der Referenzachse ($A_{ref}$) oder außerhalb der durch das magnetische Objekt verlaufenden Senkrechten zur Referenzachse ($A_{ref}$) positioniert ist.

11. Verfahren nach einem der Ansprüche 1 bis 10, wobei das mindestens eine Magnetometer (M) im Verhältnis zum magnetischen Objekt an einer Koordinate z entlang einer Achse ($e_z$), die parallel zur Referenzachse ($A_{ref}$) verläuft, und an einer Koordinate r entlang einer Achse ($e_r$), die orthogonal zur Referenzachse ($A_{ref}$) verläuft, positioniert wird, so dass die Koordinate z größer oder gleich der Koordinate r ist.

12. Verfahren zum Charakterisieren eines magnetischen Objekts (2), das eine Winkelabweichung ($\overline{\alpha}$) zwischen einer Referenzachse ($A_{ref}$) des magnetischen Objekts (2) und einer magnetischen Achse, die kolinear zu einem magnetischen Moment (**m**) des magnetischen Objekts (2) verläuft, aufweist, umfassend die folgenden Schritte:

- Implementieren des Verfahrens zum Schätzen der Winkelabweichung ($\overline{\alpha}$) nach einem der Ansprüche 2 bis 11 in Abhängigkeit von Anspruch 2;
- Berechnen einer Amplitude (m) des mit dem magnetischen Objekt (2) verbundenen magnetischen Moments (**m**) anhand der geschätzten Winkelabweichung ($\overline{\alpha}$), des identifizierten maximalen Magnetfelds ($\mathbf{B}^{\mathbf{d}}_{\mathbf{max}}$) und der geometrischen Parameter (r,z; d).

13. Verfahren nach Anspruch 12, wobei die Amplitude (m) des magnetischen Moments anhand des Verhältnisses zwischen der Norm des maximalen Magnetfelds ($\mathbf{B}^{\mathbf{d}}_{\mathbf{max}}$) und der Norm eines Magnetfelds ($\hat{\mathbf{B}}^{\mathbf{d}}_{\mathbf{max}}(\overline{\alpha}, r, z)$) für eine Einheitsamplitude des Magnetfelds (**m**) berechnet wird, analytisch ausgedrückt unter Verwendung des folgenden Gleichung:

$$\hat{\mathbf{B}}^{\mathbf{d}}_{\mathbf{max}}(\overline{\alpha}, r, z) = \frac{b}{d^5}\begin{pmatrix} -\sin(\overline{\alpha})\dfrac{d^2}{a} + \sin(\overline{\alpha})r^2 + \cos(\overline{\alpha})rz \\ -\cos(\overline{\alpha})\dfrac{d^2}{a} + \cos(\overline{\alpha})z^2 + \sin(\overline{\alpha})rz \end{pmatrix}$$

wobei $\overline{\alpha}$ die zuvor geschätzte Winkelabweichung ist, d der Abstand zwischen dem Magnetometer (M) und dem magnetischen Objekt (2) ist, z und r Koordinaten des Magnetometers (M) im Verhältnis zum magnetischen Objekt (2) entlang einer Achse sind, die jeweils parallel ($e_z$) und orthogonal ($e_r$) zur Referenzachse ($A_{ref}$) verläuft, und wobei a und b vorbestimmte Koeffizienten sind.

**14.** Schätzungsverfahren nach Anspruch 1, umfassend die folgenden Schritte:

- Positionieren (90; 110) des magnetischen Objekts (2) gegenüber einer Messebene ($P_{mes}$), die durch eine Anordnung von Magnetometern ($M_i$) definiert wird, die dazu ausgelegt sind, ein Magnetfeld (**B**) in Gegenwart des magnetischen Objekts (2) zu messen;
- Schätzen (120) eines momentanen magnetischen Moments (**m**($t_j$)) des magnetischen Objekts (2) zu den verschiedenen Messzeitpunkten ($t_j$) anhand des gemessenen Magnetfelds (**B$_i$**($t_j$));
- Schätzen (230) der mittleren Winkelabweichung ($\overline{\alpha}$) anhand der momentanen magnetischen Momenten (**m**($t_j$)).

**15.** Verfahren nach Anspruch 14, wobei der Schritt des Schätzens (230) der mittleren Winkelabweichung ($\overline{\alpha}$) einen Unterschritt des Schätzens (231) eines invarianten Vektors (**m$_o$**), der sich um die Referenzachse ($A_{ref}$) dreht, anhand der momentanen magnetischen Momenten (**m**($t_j$)) umfasst, wobei das Schätzen (230) der mittleren Winkelabweichung ($\overline{\alpha}$) ferner anhand des invarianten Vektors (**m$_o$**) ausgeführt wird.

**16.** Vorrichtung zum Schätzen (1) einer Winkelabweichung ($\overline{\alpha}$) zwischen einer Referenzachse ($A_{ref}$) eines magnetischen Objekts (2) und einer magnetischen Achse, die kolinear zu einem magnetischen Moment (m) des magnetischen Objekts (2) verläuft, umfassend:

- mindestens ein Magnetometer ($M_i$), das dazu ausgelegt ist, ein durch das magnetische Objekt (2) gestörtes Magnetfeld zu jedem Messzeitpunkt einer Dauer (T) zu messen;
- ein Halte- und Drehbauteil (7), das dazu ausgelegt ist, das magnetische Objekt (2) in einer bestimmten Position gegenüber dem mindestens einen Magnetometer ($M_i$) festzuhalten und das magnetische Objekt (2) entlang seiner Referenzachse ($A_{ref}$) in Drehung zu versetzen;
- einen Prozessor (5), der dazu konfiguriert ist, das Verfahren nach einem der Ansprüche 1 bis 15 zu implementieren.

**17.** Informationsaufzeichnungsmedium, das Anweisungen umfasst, die die Schätzvorrichtung (1) nach Anspruch 16 dazu veranlassen, die Schritte des Verfahrens nach einem der Ansprüche 1 bis 15 auszuführen.

**Claims**

**1.** A method for estimating an angular deviation ($\overline{\alpha}$) between a reference axis ($A_{ref}$) of a magnetic object (2) and a magnetic axis colinear to a magnetic moment (m) of said magnetic object (2), including the following steps:

a) positioning (90; 110) said magnetic object (2) with respect to at least one magnetometer ($M_i$) capable of measuring a magnetic field (B) in the presence of the magnetic object (2);
b) rotating (110) said magnetic object (2) around said reference axis ($A_{ref}$);
c) measuring (110), during the rotation, the magnetic field ($B_i$($t_j$)), for different instants ($t_j$) of a measurement duration (T), by said magnetometer ($M_i$);
d) estimating (130; 230) the angular deviation ($\overline{\alpha}$) from the measurements ($B_i$($t_j$)) of the magnetic field ($B_i$).

**2.** The method according to claim 1, wherein the estimation step (130) includes:

- a sub-step of identifying a magnetic field called minimum magnetic field ($B_{min}^d$) and a magnetic field called maximum magnetic field ($B_{max}^d$) from the measurements ($B^d$($t_j$)) of the magnetic field ($B^d$); and

- a sub-step of calculating the angular deviation ($\overline{\alpha}$) from the identified minimum ($B_{min}^d$) and maximum ($B_{max}^d$) magnetic fields, and geometric parameters (r,z; d) representative of the position of the magnetometer (M) relative to the magnetic object (2).

**3.** The method according to claim 2, wherein, during the identification sub-step, the minimum ($B_{min}^d$) and maximum ($B_{max}^d$) magnetic fields are respectively identified from the minimum and maximum values of the norm ($\|B^d(t_j)\|$) of the measurements ($B^d$($t_j$)) of the magnetic field ($B^d$).

4. The method according to claim 2 or 3, wherein said geometric parameters (r,z; d) are the coordinates (r,z) and the distance (d) of the magnetometer (M) relative to the magnetic object (2), in a plane passing through the reference axis ($A_{ref}$) and containing the magnetometer (M).

5. The method according to any one of claims 2 to 4, wherein the angular deviation ($\overline{\alpha}$) is calculated from a coefficient (CV) equal to the ratio of the norm of the vector formed from the subtraction of the minimum ( $B_{min}^d$ ) and maximum ( $B_{max}^d$ ) magnetic fields on the norm of the vector formed from the sum of the minimum ( $B_{min}^d$ ) and maximum ( $B_{max}^d$ ) magnetic fields and from said geometric parameters (r,z; d).

6. The method according to any one of claims 2 to 5, wherein the angular deviation ($\overline{\alpha}$) is calculated from the following equation:

$$\overline{\alpha} = \tan^{-1}\left(\left(\frac{\|\mathbf{B_{max}^d} - \mathbf{B_{min}^d}\|}{\|\mathbf{B_{max}^d} + \mathbf{B_{min}^d}\|}\right) \cdot \left(\frac{\sqrt{r^2 z^2 + \left(z^2 - d^2/a\right)^2}}{\sqrt{r^2 z^2 + \left(r^2 - d^2/a\right)^2}}\right)\right)$$

where d is the distance between the magnetometer and the magnetic object, z and r are coordinates of the magnetometer relative to the magnetic object along an axis, respectively parallel ($e_z$) and orthogonal ($e_r$), to the reference axis ($A_{ref}$), and where a is a predetermined coefficient.

7. The method according to any one of claims 1 to 6, wherein, during the rotation step, the magnetic object (2) makes at least one revolution around the reference axis ($A_{ref}$).

8. The method according to any one of claims 1 to 7, wherein said at least one magnetometer (M) includes at least three magnetic field detection axes, said detection axes being non-parallel to each other.

9. The method according to any one of claims 1 to 8, wherein said at least one magnetometer (M) is a single three-axis magnetometer.

10. The method according to any one of claims 1 to 9, wherein said at least one magnetometer (M) is positioned outside the reference axis ($A_{ref}$) or outside the perpendicular to the reference axis ($A_{ref}$) passing through the magnetic object.

11. The method according to any one of claims 1 to 10, wherein said at least one magnetometer (M) is positioned relative to said magnetic object at a coordinate z along an axis ($e_z$) parallel to the reference axis ($A_{ref}$) and a coordinate r along an axis ($e_r$) orthogonal to the reference axis ($A_{ref}$), such that the coordinate z is greater than or equal to the coordinate r.

12. A method for characterising a magnetic object (2) having an angular deviation ($\overline{\alpha}$) between a reference axis ($A_{ref}$) of said magnetic object (2) and a collinear magnetic axis at a magnetic moment (m) of said magnetic object (2), including the following steps:

- implementing the method for estimating the angular deviation ($\overline{\alpha}$) according to any one of claims 2 to 11 depending on claim 2;
- calculating an amplitude (m) of the magnetic moment (m) associated with the magnetic object (2), from the estimated angular deviation ($\overline{\alpha}$), the maximum identified magnetic field ( $B_{max}^d$ ), and said geometric parameters (r,z; d).

13. The method according to claim 12, wherein the amplitude (m) of the magnetic moment is calculated from the ratio between the norm of the maximum magnetic field ( $B_{max}^d$ ) and the norm of a magnetic field ( $\hat{B}_{max}^d(\overline{\alpha}, r, z)$ ), for a unit amplitude of said magnetic moment (m), expressed analytically by the following equation:

$$\widehat{\mathbf{B}}_{\mathbf{max}}^{\mathbf{d}}(\overline{\alpha}, \mathrm{r}, \mathrm{z}) = \frac{\mathrm{b}}{\mathrm{d}^5}\begin{pmatrix} -\sin(\overline{\alpha})\dfrac{\mathrm{d}^2}{\mathrm{a}} + \sin(\overline{\alpha})\mathrm{r}^2 + \cos(\overline{\alpha})\mathrm{rz} \\ -\cos(\overline{\alpha})\dfrac{\mathrm{d}^2}{\mathrm{a}} + \cos(\overline{\alpha})\mathrm{z}^2 + \sin(\overline{\alpha})\mathrm{rz} \end{pmatrix}$$

where $\overline{\alpha}$ is the previously estimated angular deviation, d is the distance between the magnetometer (M) and the magnetic object (2), z and r are coordinates of the magnetometer (M) relative to the magnetic object (2) along an axis, respectively parallel ($e_z$) and orthogonal ($e_r$), to the reference axis ($A_{ref}$), and where a and b are predetermined coefficients.

14. The estimation method according to claim 1, including the following steps:

    - positioning (90; 110) said magnetic object (2) with respect to a measurement plane ($P_{mes}$) defined by a network of magnetometers ($M_i$) capable of measuring a magnetic field (B) in the presence of the magnetic object (2);
    - estimating (120) a magnetic moment called instantaneous magnetic moment ($m(t_j)$) of the magnetic object (2), at said different measurement instants ($t_j$), from the measured magnetic field ($B_i(t_j)$);
    - estimating (230) the angular deviation called average angular deviation ($\overline{\alpha}$) from said instantaneous magnetic moments ($m(t_j)$).

15. The method according to claim 14, wherein the step of estimating (230) the average angular deviation ($\overline{\alpha}$) includes a sub-step of estimating (231) a vector ($m_o$) invariant in rotation around the reference axis ($A_{ref}$) from the instantaneous magnetic moments ($m(t_j)$), the estimation (230) of the average angular deviation ($\overline{\alpha}$) being carried out, in addition, from said invariant vector ($m_o$).

16. A device for estimating (1) an angular deviation ($\overline{\alpha}$) between a reference axis ($A_{ref}$) of a magnetic object (2) and a magnetic axis colinear to a magnetic moment (m) of said magnetic object (2), including:

    - at least one magnetometer ($M_i$) capable of measuring, at each measurement instant of a duration (T), a magnetic field disturbed by the magnetic object (2);
    - a holding and rotation member (7), capable of maintaining the magnetic object (2) in a determined position with respect to said at least one magnetometer ($M_i$), and of rotating the magnetic object (2) around its reference axis ($A_{ref}$);
    - a processor (5) configured to implement the method according to any one of claims 1 to 15.

17. A medium for recording information, including instructions which lead the estimation device (1) according to claim 16 to execute the steps of the method according to any one of claims 1 to 15.

**Fig.1**

**Fig.3A**

**Fig.3B**

**Fig.2**

**Fig.4A**

**Fig.4B**

**Fig.5**

**Fig.6A**

**Fig.6B**

**Fig.6C**

**Fig.6D**

**Fig.6E**

**Fig.7**

**Fig.8A**

**Fig.8B**

120 →

121

$\mathbf{B}_i^d(t_j)$

122

$\{\mathbf{m}(t_j)\}_N$

150 →

151

$\sigma(\|\mathbf{m}(t_j)\|)$

152

$\{\widehat{\boldsymbol{m}}(t_j)\}_N$

230 →

231

$\mathbf{m_0}$

232

$\bar{R}$

233

$\bar{\alpha}$

**Fig.9**

**Fig.10A**

**Fig.10B**

## RÉFÉRENCES CITÉES DANS LA DESCRIPTION

**Documents brevets cités dans la description**

- WO 2014053526 A

- FR 3003039 A1